# EUROPEAN PATENT SPECIFICATION

(11) **EP 2 341 107 B1**
(45) Date of publication and mention of the grant of the patent: **30.07.2014**
(21) Application number: 09773690.4
(22) Date of filing: 29.06.2009
(51) Int. Cl.: C09B 57/00, C09B 23/00, C09B 23/14, H01G 9/20, H01L 51/00

(54) **NOVEL ORGANIC DYE AND METHOD FOR PREPARING SAME**
NEUER ORGANISCHER FARBSTOFF UND SEINE HERSTELLUNG
NOUVEAU COLORANT ORGANIQUE ET SON PROCEDE DE PREPARATION

(30) Priority: 30.06.2008 KR 20080062487; 26.06.2009 KR 20090057534
(43) Date of publication of application: 06.07.2011
(73) Proprietor: Dongjin Semichem Co., Ltd., Seo-gu Incheon 404-205 (KR)
(72) Inventor: LEE, Chong-chan, Chungcheongbuk-Do 363-883 (KR); BACK, Jong-hyub, Seoul 139-224 (KR); YANG, Hoe-taek, Hwaseong-City Gyeonggi-Do 445-923 (KR)
(74) Representative: Bockhorni & Kollegen
(86) International application number: PCT/KR2009/003500
(87) International publication number: WO 2010/002154

(56) References cited:
- EP-A1- 1 628 356
- EP-A1- 1 990 373
- WO-A1-2007/100033
- WO-A1-2007/119525
- JP-A- 2000 106 223
- JP-A- 2004 277 736
- JP-A- 2005 135 656
- KR-A- 20030 026 984
- KR-A- 20050 116 146
- KR-A- 20070 102 821
- US-A1- 2010 174 095
- GROENENDAAL L ET AL: "POLY(3,4-ETHYLENEDIOXYTHIOPHENE) AND ITS DERIVATIVES: PAST, PRESENT, AND FUTURE", ADVANCED MATERIALS, WILEY VCH VERLAG, DE, vol. 12, no. 7, 4 April 2000 (2000-04-04), pages 481-494, XP000949752, ISSN: 0935-9648, DOI: 10.1002/(SICI)1521-4095(200004)12:7<481::A ID-ADMA481>3.3.CO;2-3

## Description

### BACKGROUND OF THE INVENTION

### (a) Field of the Invention

The present invention relates to novel organic dye use for a dye-sensitized solar cell(DSSC) and a method for preparing the same.

### (b) Description of the Related Art

Since a dye-sensitized nanoparticle titanium oxide solar cell was developed by Michael Gratzel et al. of Swiss Federal Institute of Technology Lausanne(EPFL) at the year of 1991, many studies on this field are under progress. Because the dye-sensitized solar cell has high efficiency and remarkably low manufacture cost compared to the existing silicon solar cell, it may replace the existing amorphous silicon solar cell. The dye-sensitized solar cell is a photoelectrochemical solar cell mainly comprising dye molecules capable of absorbing visible rays to generate electron-hole pair, and transition metal oxide for transmitting the generated electrons.

As dyes for dye-sensitized solar cell, ruthenium metal complex which shows high photoelectric transformation efficiency has been widely used. However, ruthenium metal complex is too expensive.

Recently, it has been found that organic dyes which do not comprise metal and show excellent properties in terms of absorption efficiency, oxidation reduction stability, and intramolecular charge-transfer(CT) absorption may be used for dye for a solar cell replacing expensive ruthenium metal complex. Thus, studies focus on organic dyes free of metal.

Organic dyes are generally comprised of electron donor-electron acceptor residue connected by π-bond unit. For most organic dyes, amine derivatives function as electron-donor, and 2-cyanoacrylic acid or rhodanine residue functions as electron-acceptor, and they are connected by π-bond system such as methaine unit or thiophene chain.

For example, EP 1 990 373 A1 describes such a dye and a photoelectric conversion device comprising the same, wherein the methine dye is supported by a thin film of oxide semiconductor particles arranged on a substrate. The photoelectric conversion device is manufactured for being used in a solar cell.

Generally, structural change of electron-donor amine unit brings change in electron properties, for example blue-shifted absorption spectrum, and change in π-bond length to control absorption spectrum and redox potential.

However, most organic dyes known so far have low transformation efficiency and driving stability compared to ruthenium metal complex dyes. Therefore, there have been continuous attempts to develop novel dyes having improved molar absorption coefficient and high photoelectric transformation efficiency compared to the existing organic dyes by changing the kinds of electron-donor and electron-acceptor or the length of π-bond.

JP 2004 277736 A describes a solar cell comprising an oligomer based on thiophene units, wherein one thiophene unit has a cyano- or methyl-substituted fullerene residue. The thiophene units function as π-bond unit and the fullerene residue has a high electronic receptiveness.

### SUMMARY OF THE INVENTION

Accordingly, it is an object of the present invention to provide alternative organic dye which exhibits improved molar absorption coefficient and photoelectric transformation efficiency thus largely improving solar cell efficiency, and a method for preparing the same.

It is another object of the present invention to provide a dye-sensitized photoelectric transformation element comprising the above dye, which shows excellent photoelectric transformation efficiency, J_{sc}(short circuit photocurrent density) and molar absorption coefficient, and a solar cell having remarkably improved efficiency.

In order to achieve the object, the present invention provides organic dye represented by the following Chemical Formula 1: 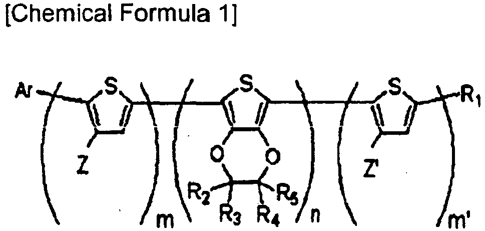 wherein
R1 is or 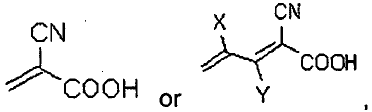 X and Y are independently hydrogen or C1-6 alkyl;
R2 to R5 are independently hydrogen, substituted or unsubstituted C1-30 alkyl or C1-30 alkoxy;
Ar is 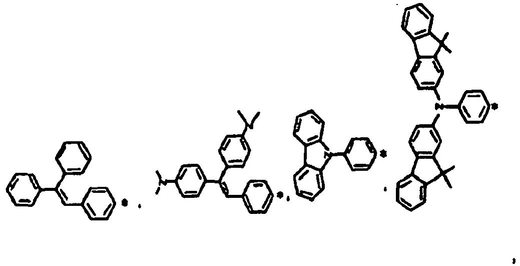 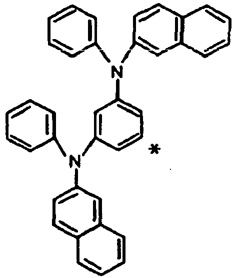 (* is a bonding part),
Z and Z' are hexyl;
n is an integer of from 1 to 10;
m and m' are independently an integer of from 0 to 5, provided that both m and m' are not simultaneously 0, and preferably 1 or 2.

The present invention also provides a method for preparing organic dye of the following Chemical Formula 1-1(a compound of the Chemical Formula 1 wherein m' is 0) comprising:
(1) preparing a compound of the following Chemical Formula 4 by Suzuki coupling reaction of a compound of the following Chemical Formula 2 with a compound of the following Chemical Formula 3,
(2) preparing a compound of the following Chemical Formula 5 by reacting the compound of the Chemical Formula 4 with POCl₃ in an organic solvent,
(3) reacting the compound of the Chemical Formula 5 with cyanoacetic acid or a compound of the following Chemical Formula 6 in CH₃CN in the presence of piperidine.

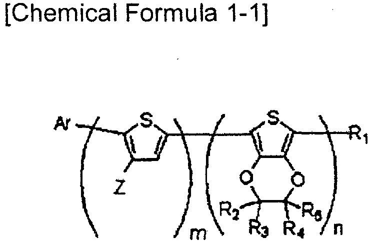

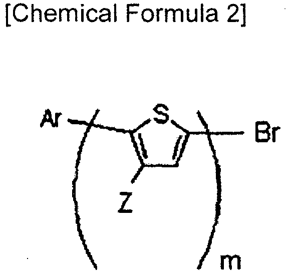

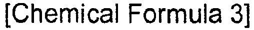

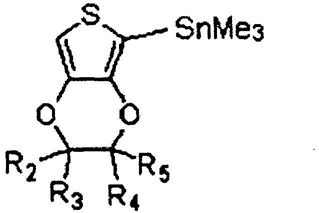

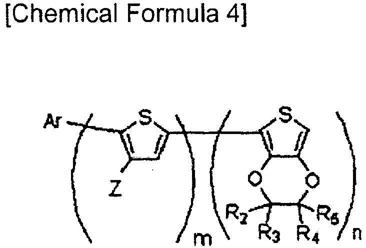

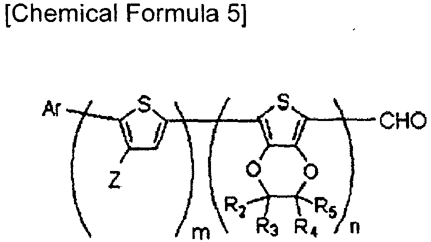

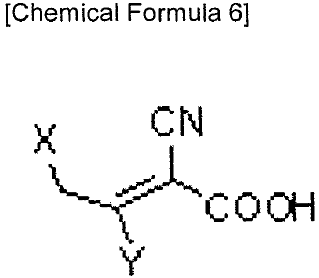

Wherein, X, Y, R1 to R5, Ar, Z, m and n are as defined above.

The present invention also provides a method for preparing organic dye of the following Chemical Formula 1-2(a compound of the Chemical Formula 1 wherein m' is not 0) comprising:
(i) preparing a compound of the following Chemical Formula 4 by Suzuki coupling reaction of a compound of the following Chemical Formula 2 with a compound of the following Chemical Formula 3,
(ii) preparing a compound of the following Chemical Formula 7 by reacting the compound of the Chemical Formula 4 with N-bromostyrene in an organic solvent,
(iii) preparing a compound of the following Chemical Formula 9 by Suzuki coupling reaction of the compound of the Chemical Formula 7 with a compound of the following Chemical Formula 8,
(iv) preparing a compound of the following Chemical Formula 10 by reacting the compound of the Chemical Formula 9 with POCl3 in an organic solvent, and
(v) reacting the compound of the Chemical Formula 10 with cyanoacetic acid or a compound of the following Chemical Formula 6 in CH3CN in the presence of piperidine:

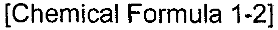

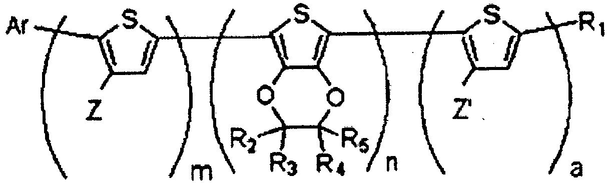

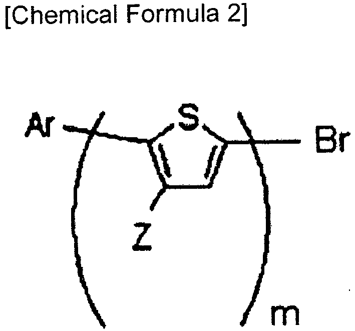

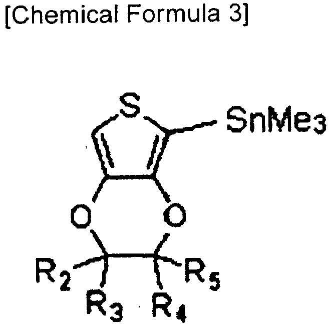

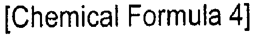

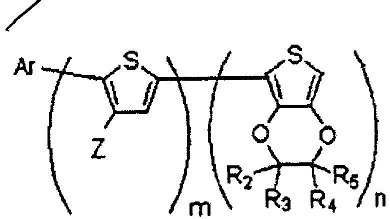

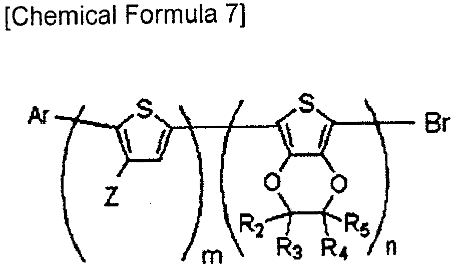

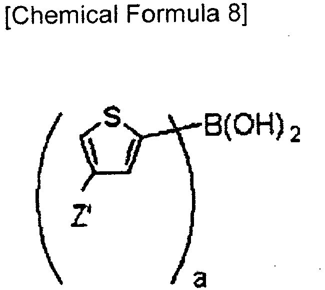

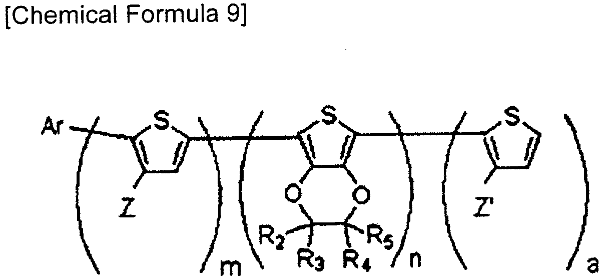

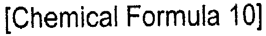

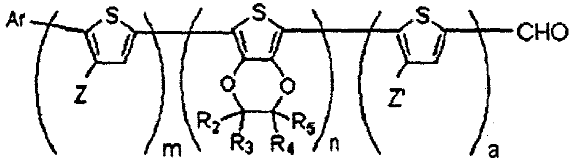

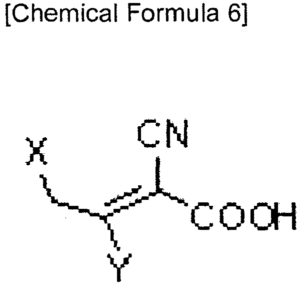

wherein, X, Y, R1 to R5, Ar, Z, Z', m and n are as defined above, and
a is an integer of from 1 to 5, preferably 1 or 2.

The present invention also provides a dye-sensitized photoelectric transformation element comprising oxide semiconductor particles where the compound of the Chemical Formula 1 is supported.

The present invention also provides a dye-sensitized solar cell comprising the dye-sensitized photoelectric transformation element.

The dye compound of the present invention, if used for a dye-sensitized solar cell(DSSC), shows improved molar absorption coefficient, J_{sc}(shortcircuit photocurrent density) and photoelectric transformation efficiency compared to the existing dyes, thus largely improving solar cell efficiency, and it may be purified without expensive column thus remarkably lowering dye synthesis cost.

### DETAILED DESCRIPTION OF THE EMBODIMENTS

The inventors confirmed that when a compound of the Chemical Formula 1 which uses 2,3-dihydrothieno[3,4-b][1,4]dioxin, introduces a thiophene unit in the intermediate bonding part for increasing molar absorption coefficient and device stability, and uses cyanoacrylic acid well adapted to TiO2 modification and having most excellent electron transferring capability as electron acceptor is supported in an oxide semiconductor particles to prepare a dye-sensitized solar cell, high photoelectric transformation efficiency, J_{sc}(shortcircuit photocurrent density) and molar absorption coefficient may be obtained to show excellent efficiency compared to the existing dye-sensitized solar cell, and completed the invention.

The organic dye of the present invention is represented by the following Chemical Formula 1, preferably one of the following Chemical Formula 1a to 1x.

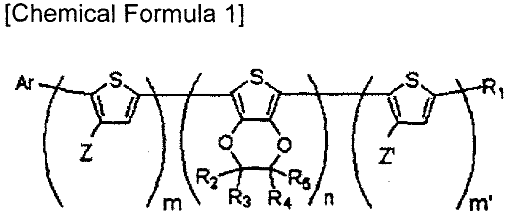

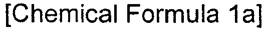

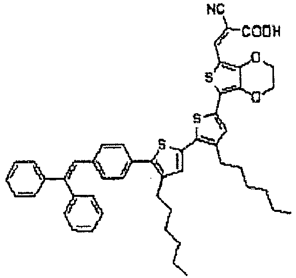

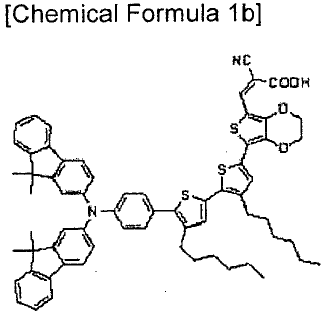

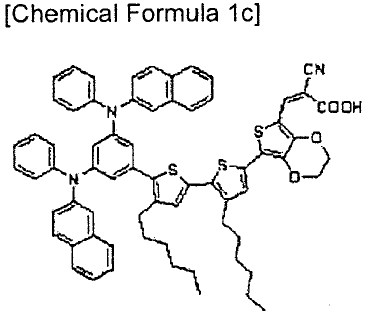

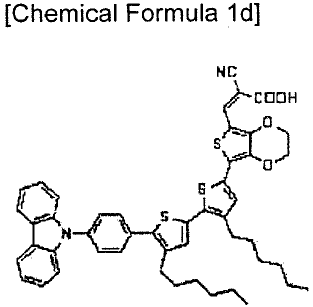

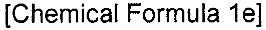

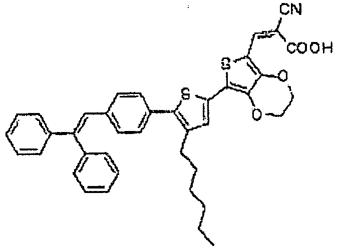

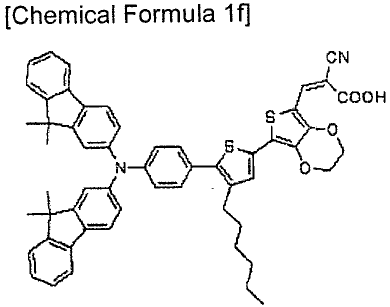

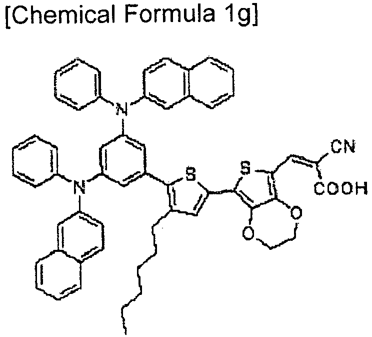

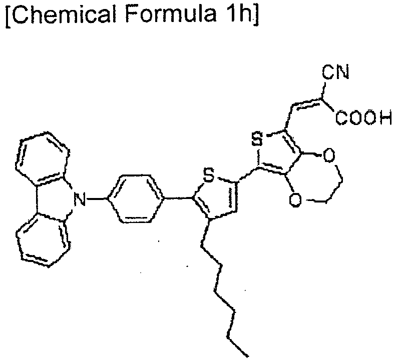

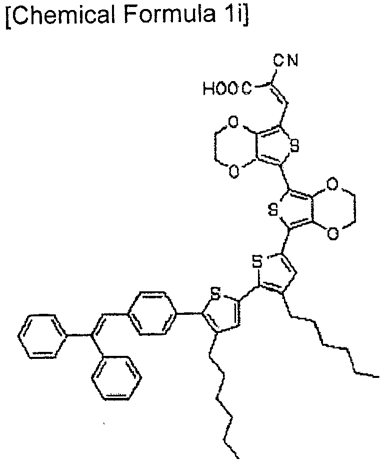

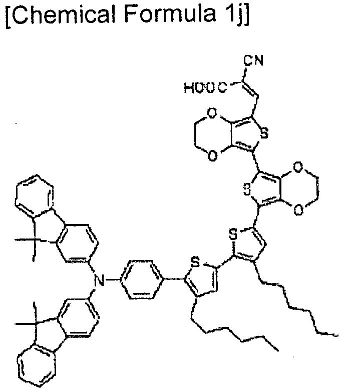

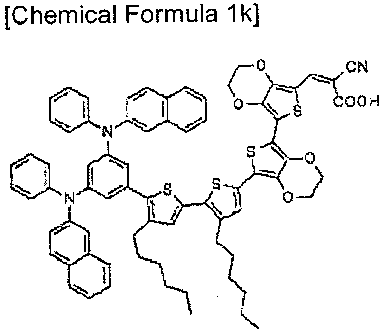

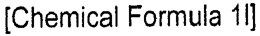

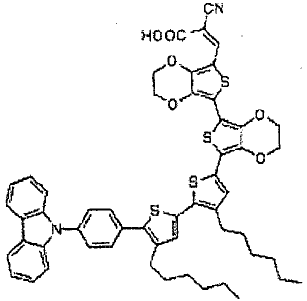

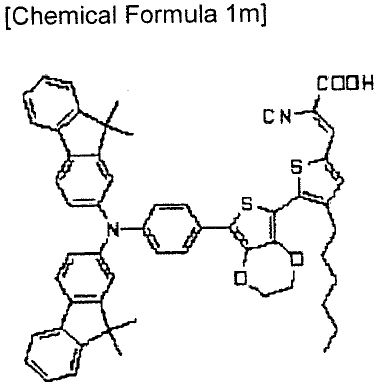

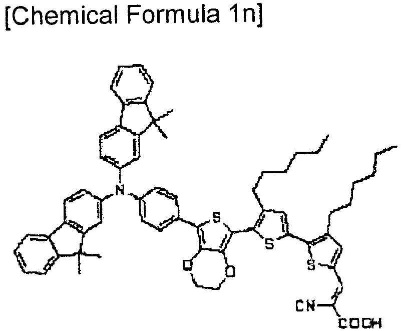

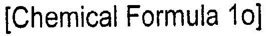

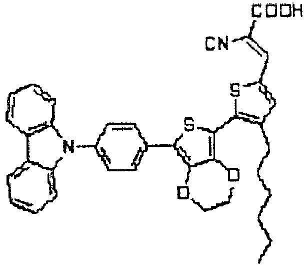

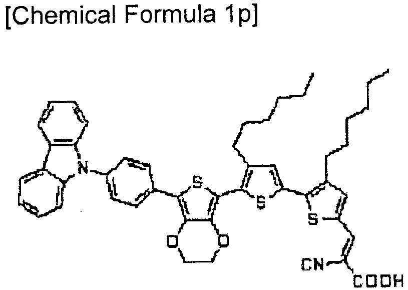

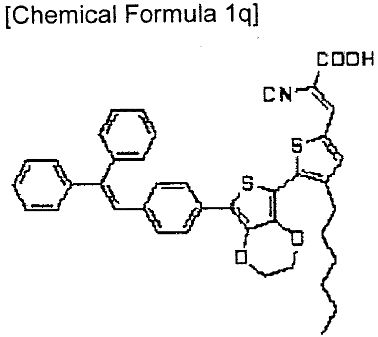

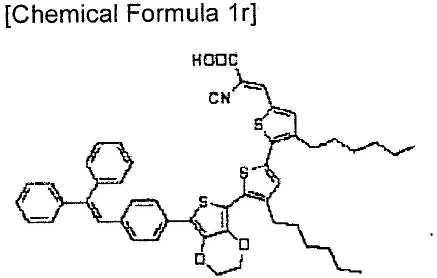

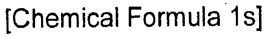

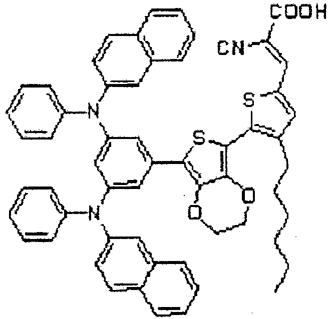

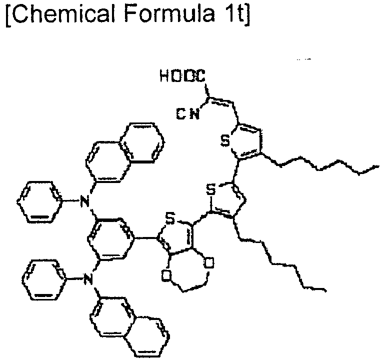

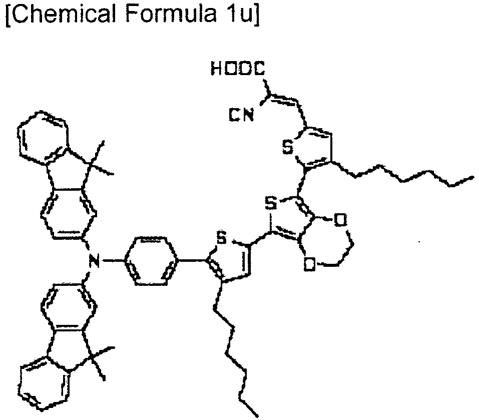

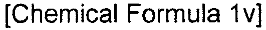

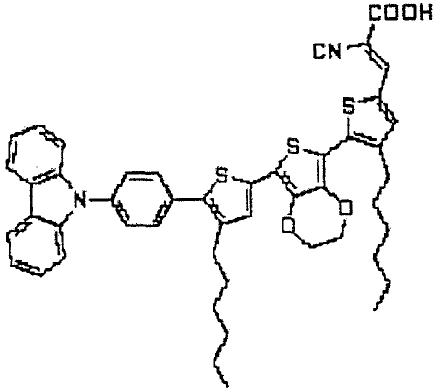

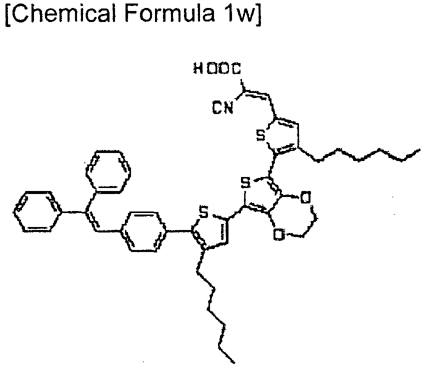

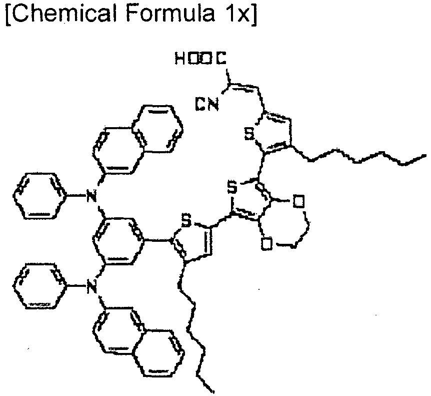

Wherein, R1 to R5, Ar, Z, Z', m, n and m' are as defined above.

The present invention also provides a method for preparing organic dye of the following Chemical Formula 1-1 wherein m' is 0, which comprises (1) preparing a compound of the following Chemical Formula 4 by Suzuki coupling reaction of a compound of the following Chemical Formula 2 with a compound of the following Chemical Formula 3, (2) preparing a compound of the following Chemical Formula 5 by reacting the compound of the Chemical Formula 4 with POCl3 in an organic solvent, (3) reacting the compound of the Chemical Formula 5 with cyanoacetic acid or a compound of the following Chemical Formula 6 in CH3CN in the presence of piperidine. Specific example of the method may be represented by the following Equations 1 to 4 (Equation 1: a compound of the Chemical Formula 1a, Equation 2: a compound of the Chemical Formula 1b, Equation 3: a compound of the Chemical Formula 1 e, Equation 4: a compound of the Chemical Formula 1f). 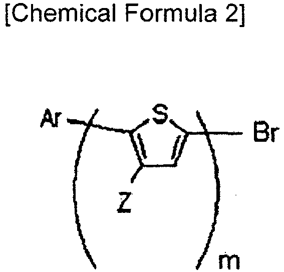 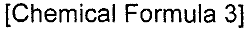 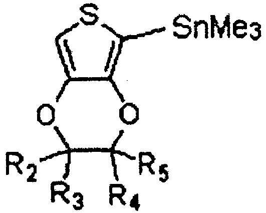 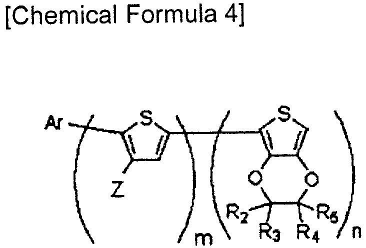 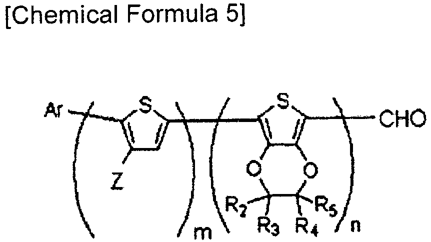 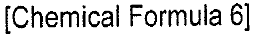 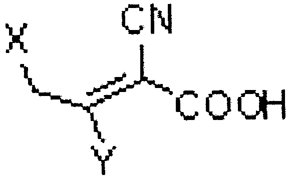 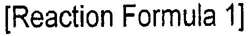 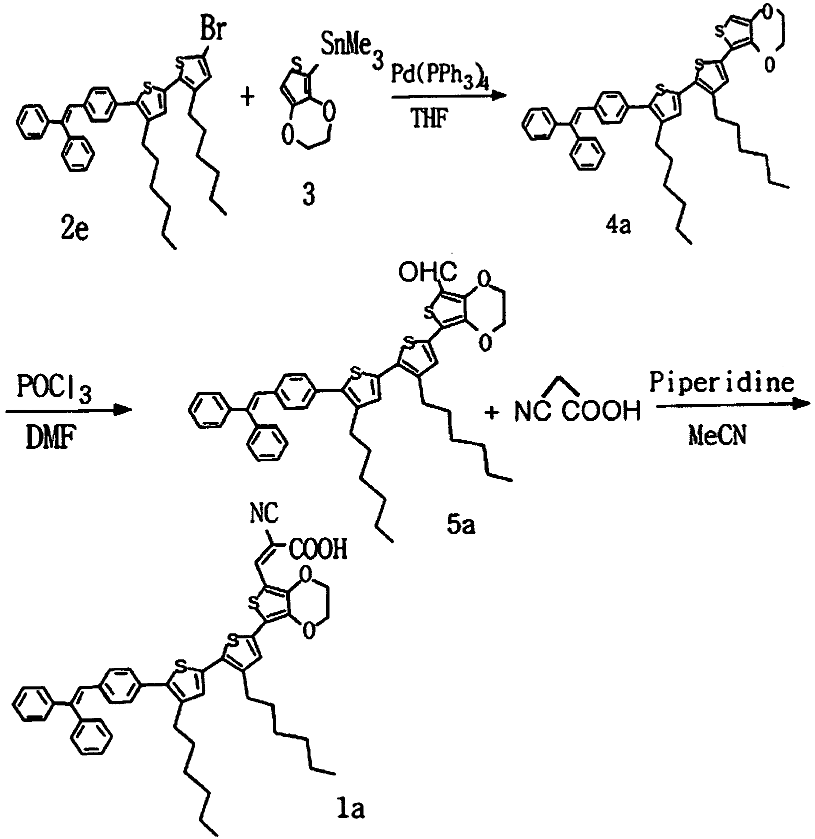 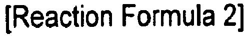 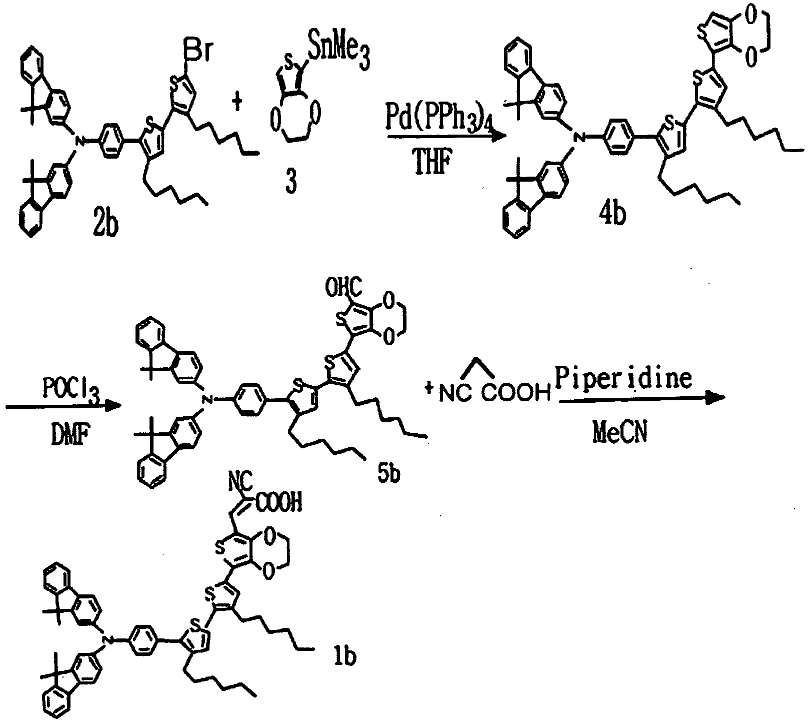 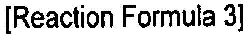 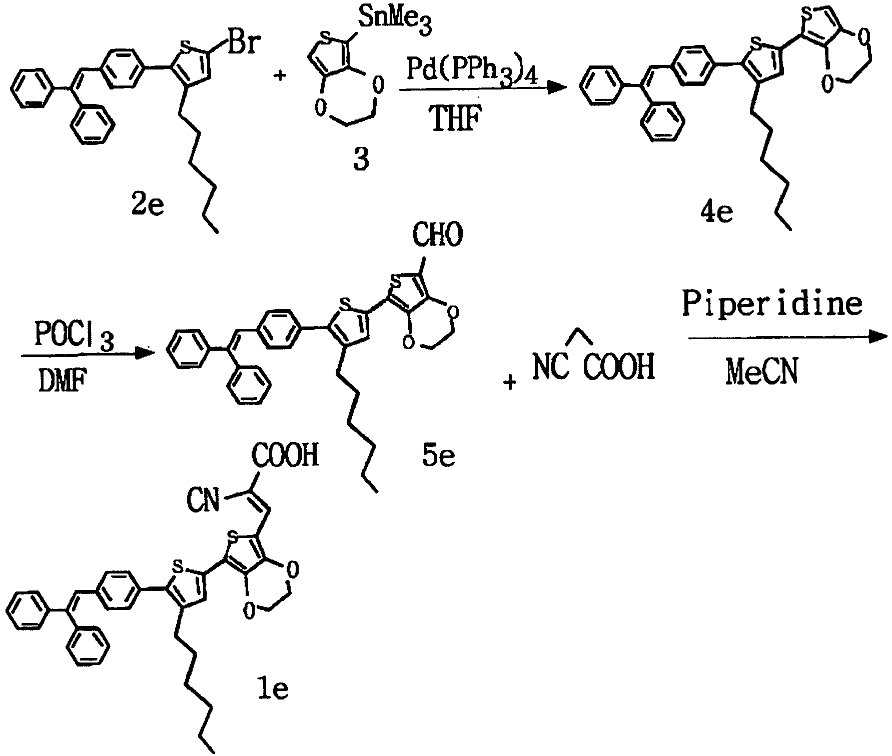 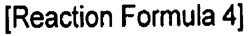 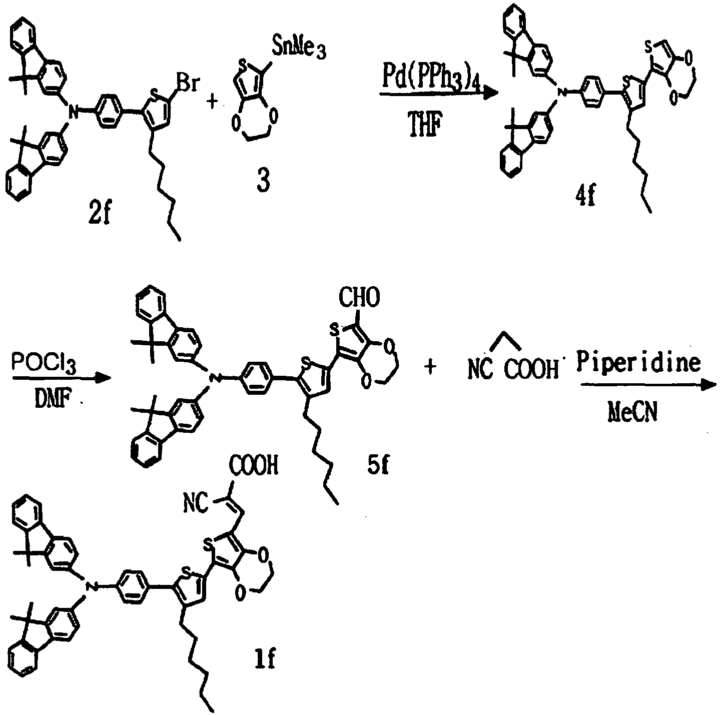 Wherein, R2 to R5, X, Y, Ar, Z, m and n are as defined above.

The present invention also provides a method for preparing organic dye of the following Chemical Formula 1-2 wherein m' is not 0, which comprises (i) preparing a compound of the following Chemical Formula 4 by Suzuki coupling reaction of a compound of the following Chemical Formula 2 with a compound of the following Chemical Formula 3, (ii) preparing a compound of the following Chemical Formula 7 by reacting the compound of the Chemical Formula 4 with N-bromostyrene in an organic solvent (e.g., tetrahydrufuran), (iii) preparing a compound of the following Chemical Formula 9 by Suzuki coupling reaction of the compound of the Chemical Formula 7 with a compound of the following Chemical Formula 8, (iv) preparing a compound of the following Chemical Formula 10 by reacting the compound of the Chemical Formula 9 with POCl3 in an organic solvent (e.g., dimethylformamide), and (v) reacting the compound of the Chemical Formula 10 with cyanoacetic acid or a compound of the following Chemical Formula 6 in CH3CN in the presence of piperidine. Specific example of the method may be represented by the following Equations 5 to 10 (Equation 5: a compound of the Chemical Formula 1n, Equation 6: a compound of the Chemical Formula 1r, Equation 7: a compound of the Chemical Formula 1q, Equation 8: a compound of the Chemical Formula 1 m, Equation 9: a compound of the Chemical Formula 1w, Equation 10: a compound of the Chemical Formula 1u). 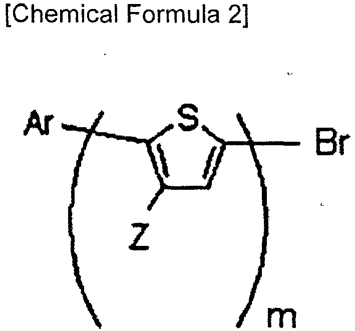 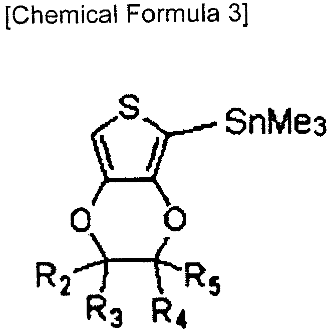 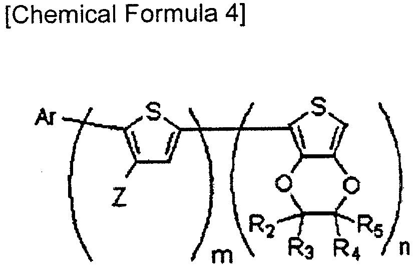 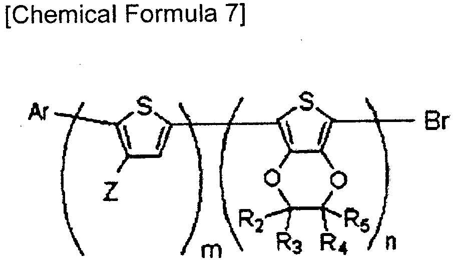 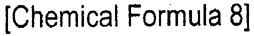 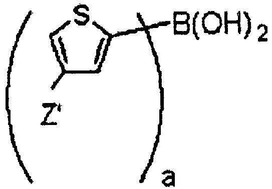 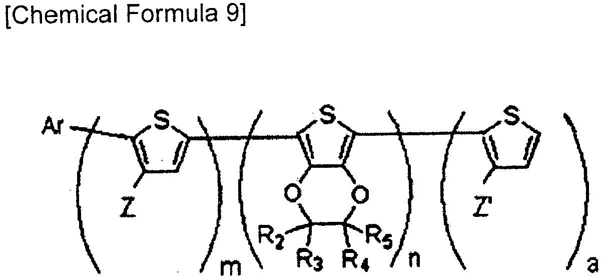 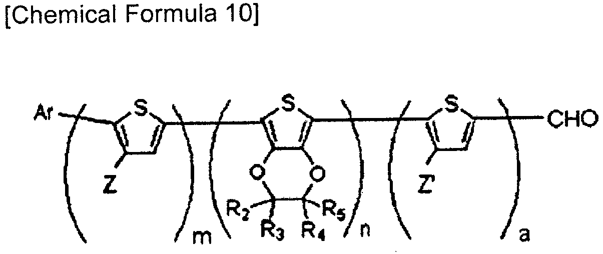 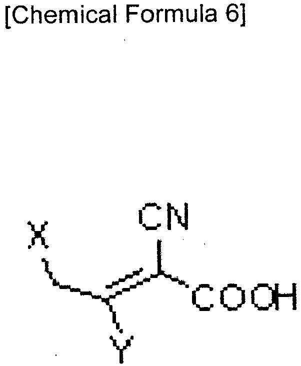 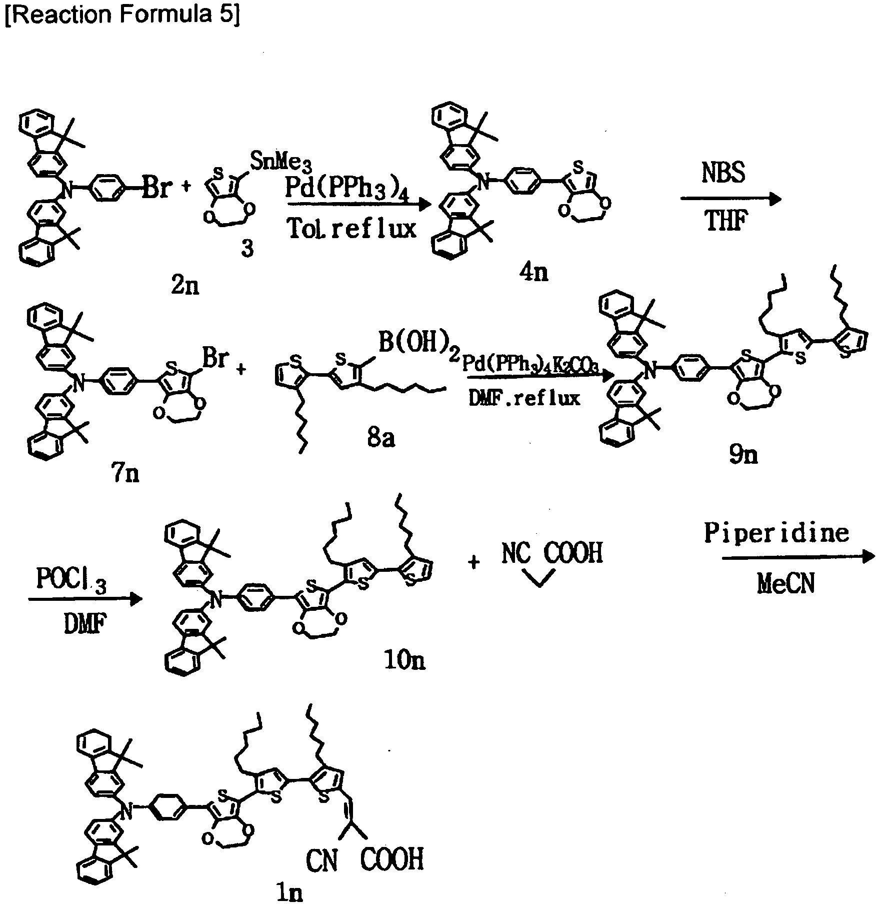 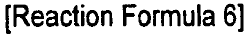 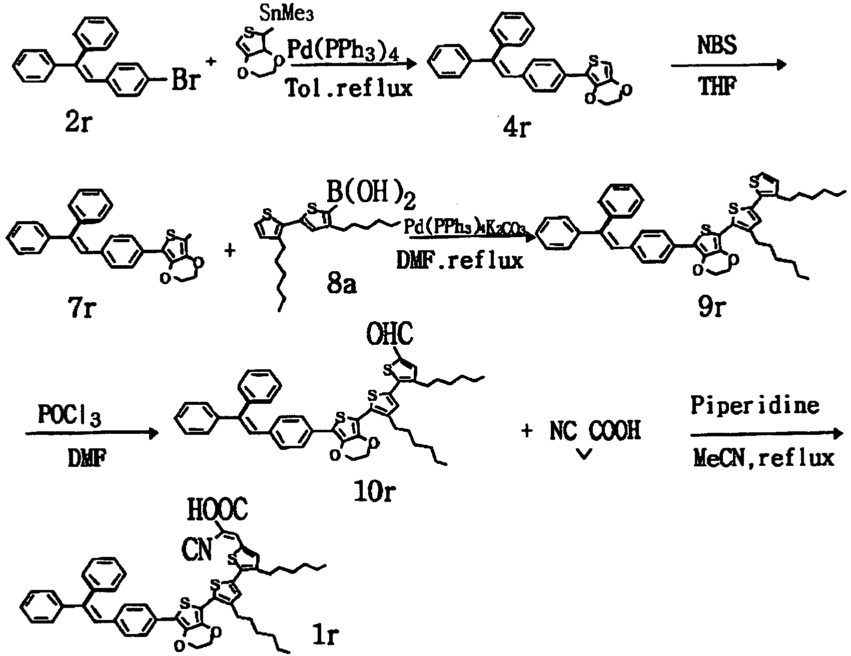 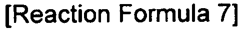 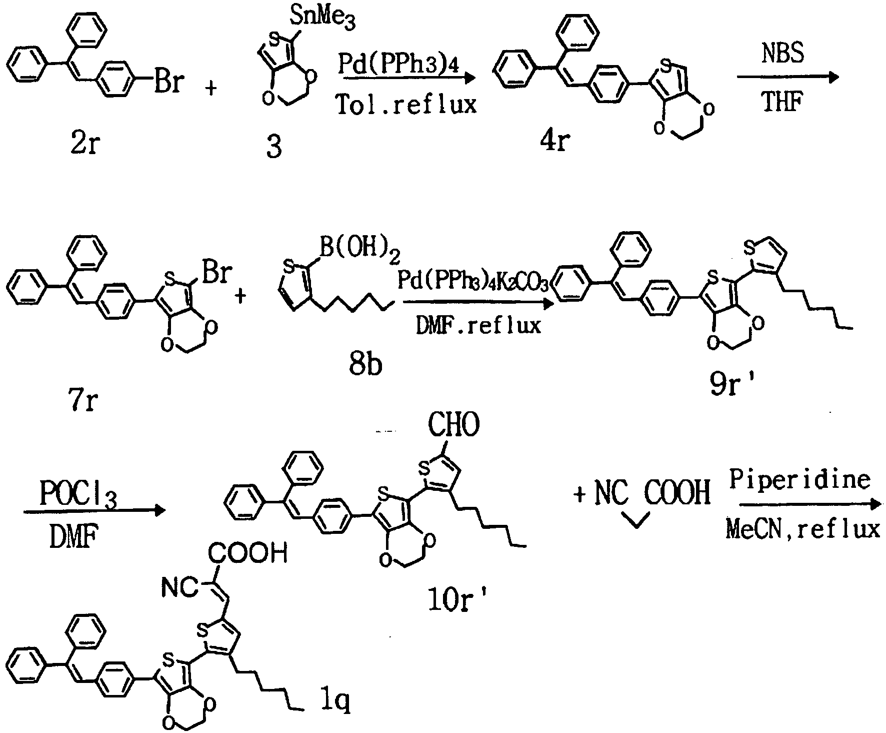 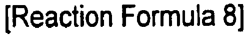 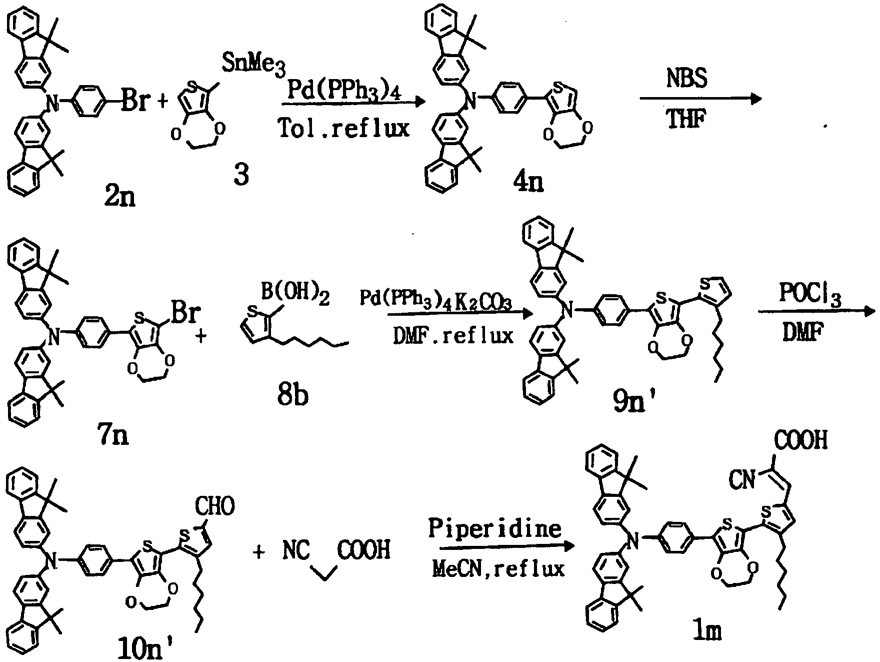 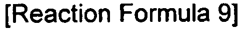 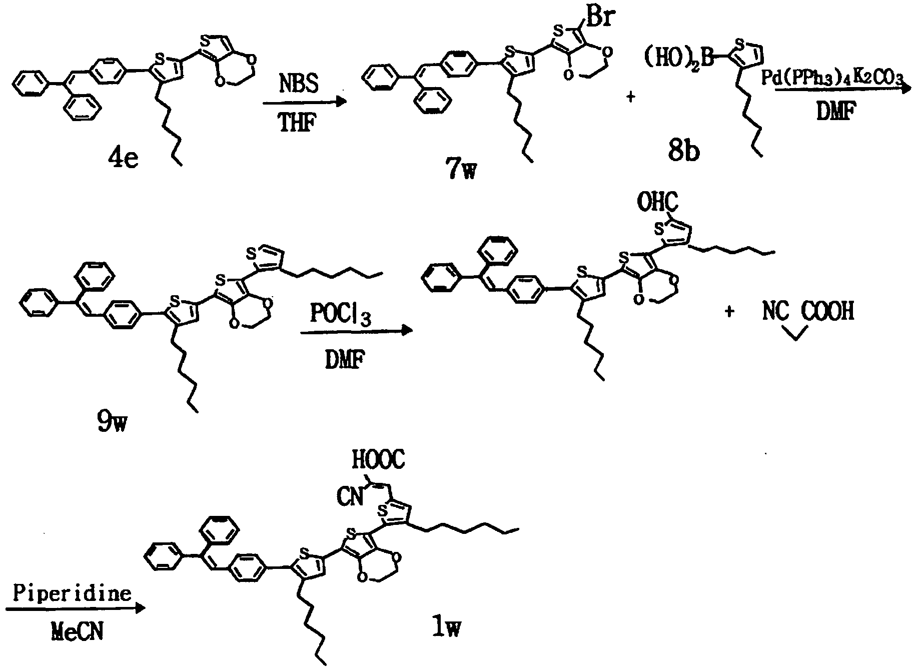 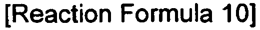 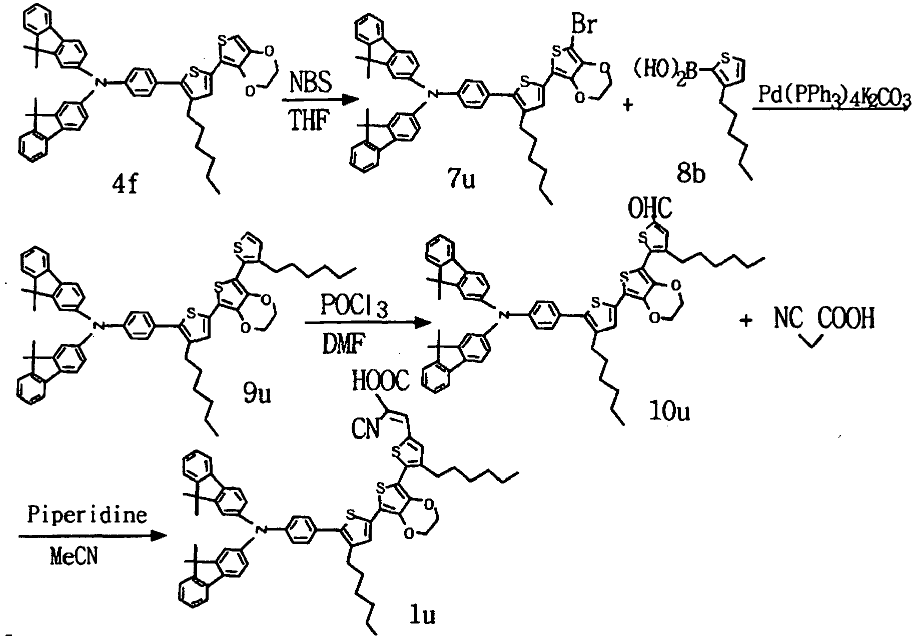 wherein, R2 to R5, X, Y, Ar, Z, Z', m, n and a are as defined above.

In the above Equations, compounds of the Chemical Formulae 2a, 2b, 2e, 2f, 2n and 2r, and 3, which are used as a starting material for preparing the dye of the Chemical Formula 1, may be prepared by common methods or purchased.

The present invention also provides a dye-sensitized photoelectric transformation element wherein the dye represented by the Chemical Formula 1 is supported on oxide semiconductor particles. The photoelectric transformation element of the present invention may be prepared by a process for preparing dye-sensitized photoelectric transformation element for solar cell of the prior art, except using the dye of the Chemical Formula 1. Preferably, the photoelectric transformation element of the present invention is prepared by forming oxide semiconductor thin film on a substrate and then supporting the dye of the present invention on the thin film.

The substrate on which the oxide semiconductor thin film is formed preferably has a conductive surface, and is available on the market. For example, those prepared by forming a conductive metal oxide film such as indium, fluorine, antimony doped tin oxide, etc. or metal film such as steel, silver, gold, etc. on the surface of glass or on the surface of transparent polymer such as polyethyleneterephthalate or polyethersulfone, etc. may be used. Preferably, it may have conductivity of 1000Ω or less, more preferably 100Ω or less.

As the oxide semiconductor particles, metal oxide is preferable. Specific examples may include titanium, tin, zinc, tungsten, zirconium, gallium, indium, yttrium, niobium, tantalum, vanadium oxide, etc. Preferably, titanium, tin, zinc, niobium, or indium oxide may be used, titanium oxide, zinc oxide or tin oxide may be more preferable, and titanium oxide may be most preferable. The oxide semiconductor may be used alone or in a combination, or it may be coated on the surface of semiconductor.

The oxide semiconductor particles may preferably have the average diameter of 1 ~ 500 nm, more preferably 1 - 100 nm. And, those having large diameter and those having small diameter may be mixed, or used in multi-layers.

The oxide semiconductor thin film may be prepared by spraying oxide semiconductor particles to form a thin film thereof directly on a substrate; electrically depositing a semiconductor particle thin film using a substrate as an electrode; or, applying semiconductor particle slurry or paste containing particles obtained by hydrolysis of semiconductor particle precursor such as semiconductor alkoxide, etc. on a substrate, and drying, curing or sintering. Preferably, paste may be applied on a substrate, and in this case, slurry may be obtained by dispersing secondary coagulated oxide semiconductor particles in a dispersion medium to a first particle diameter of 1 - 200 nm by a common method.

As the dispersion medium, those capable of dispersing semiconductor particles may be used without limitation. Specific examples may include water, alcohol such as ethanol, ketone such as acetone, acetylaetone, or hydrocarbon such as hexane, and a combination thereof. Water may be preferable because it minimizes change in viscosity of slurry. And, a dispersion stabilizer may be used in order to stabilize the dispersion of the oxide semiconductor particles. Specific examples of the dispersion stabilizer may include acid such as acetic acid, hydrochloric acid, nitric acid, etc., or acetylacetone, acrylic acid, polyethyleneglycol, polyvinylalcohol, etc.

The substrate on which slurry is applied may be sintered, and the sintering temperature may be 100°C or more, preferably 200°C or more, and the upper limit of the sintering temperature may be melting point(softening point) of the substrate, commonly 900°C, preferably 600°C. The sintering time may not be specifically limited, but preferably within 4 hours.

Thickness of the thin film on the substrate may be 1 - 200 µm, preferably 1 - 50 µm. In case sintering is conducted, an oxide semiconductor particle thin layer may be partly welded, but such welding may not cause any influences in the present invention.

And, the oxide semiconductor thin film may be subjected to a secondary treatment. For example, the thin film may be immersed in a solution of alkoxide, chloride, nitride, sulfide, etc. of the metal identical to the semiconductor, and dried or re-sintered, thereby improving the property of the thin film. The metal alkoxide may include titanium ethoxide, titanium isoproepoxide, titanium t-butoxide, n-dibutyl-diacetyl tin, etc., and an alcohol solution thereof may be used. The chloride may include titanium tetrachloride, tin tetrachloride, zinc chloride, etc., and an aqueous solution thereof may be used. Thus obtained oxide semiconductor thin film may be comprised of oxide semiconductor particles.

The method for supporting dye on oxide semiconductor particles in the form of a thin film may not be specifically limited, and for example, a substrate having the oxide semiconductor thin film formed thereon may be immersed in a solution obtained by dissolving the dye represented by the above Chemical Formula 1 in a solvent capable of dissolving the same, or in a dispersion obtained by dispersing the dye. The concentration of the solution or dispersion may be appropriately determined. Immersion temperature may be from room temperature to boiling point of the solvent, and immersion time may be about 1 minute to 48 hours. The solvent used for dissolving the dye may include methanol, ethanol, acetonitrile, dimethylsulfoxide, dimethylformamide, acetone, t-butanol, etc. The concentration of the solution may be commonly 1 x 10⁻⁶ M to 1 M, preferably 1 x 10⁻⁵ M to 1 x 10⁻¹ M. Thus, a dye-sensitized photoelectric transformation element comprising oxide semiconductor particles on a dye-sensitized thin film may be obtained.

One kind of the dye represented by the Chemical Formula 1 may be used or several kinds of the dyes may be used in combination. In case several kinds of dyes are used in combination, only dyes according to the present invention may be used, or the dyes according to the present invention may be mixed with other dyes or metal complex dyes. The metal complex dyes that may be mixed may include, although not specifically limited, ruthenium complex or quaternary salt thereof, phthalocyanin, porphyrin, etc.; and the organic dye that may be mixed may include metal-free phthalocyanin, porphyrin, cyanin, merocyanin, oxonol, or triphenylmethane dye, methyne dye such as acrylate dye described in WO2002/011213, xanthenes, azo, anthraquinone, perylene dye(See M.K.Nazeeruddin, A.Kay, I.Rodicio, R.Humphry-Baker, E.Muller, P.Liska, N.Vlachopoulos, M.Gratzel, J. Am. Chem. Soc., Vol.115, p 6382(1993)). In case two or more kinds of dyes are used in combination, they may be sequentially absorbed in a semiconductor thin layer, or mixed, dissolved and absorbed.

When the dye is supported on the oxide semiconductor particle thin film, in order to prevent bonding between dyes, it may be preferable to support dye in the presence of an inclusion compound. The inclusion compound may include cholic acid such as deoxycholic acid, dehydrodeoxycholic acid, kenodeoxycholic acid, cholic acid methyl ester, cholic acid sodium, etc., steroid compounds such as cholic acid, polyethyleneoxide, etc., crown ether, cyclodextrin, calyxarene, polyethyleneoxide, etc.

After the dye is supported, the surface of a semiconductor electrode may be treated with an amine compound such as 4-t-butyl pyridine, or a compound having acid group such as acetic acid, propionic acid, etc. For example, a substrate having a dye-supported semiconductor particle thin film formed thereon may be immersed in an ethanol solution of amine.

The present invention also provides a dye-sensitized solar cell comprising the dye-sensitized photoelectric transformation element. It may be prepared by common method of preparing a solar cell using photoelectric transformation element of the prior art, except using a dye-sensitized photoelectric transformation element comprising oxide semiconductor particles where the dye of the Chemical Formula 1 is supported. The dye-sensitized solar cell may be comprised of a photoelectric transformation element electrode (negative electrode) wherein the dye represented by the Chemical Formula 1 is supported on the oxide semiconductor particles, a counter electrode(positive electrode), redox electrolyte, hole-transport material or p-type semiconductor, etc.

Preferably, the dye-sensitized solar cell of the present invention may be prepared by coating titanium oxide paste on a transparent conductive substrate; sintering the coated substrate to form a titanium oxide thin film; immersing the substrate having titanium oxide thin film formed thereon in a mixed solution in which the dye represented by the Chemical Formula 1 is dissolved, so as to form a dye-absorbed titanium oxide film electrode; providing a second glass substrate having a counter electrode formed thereon; forming a hole penetrating the second glass substrate and the counter electrode; placing thermoplastic polymer film between the counter electrode and the dye-absorbed titanium oxide film electrode and heat-pressing them to join the counter electrode and the titanium oxide film electrode; injecting electrolyte into the thermoplastic polymer film placed between the counter electrode and the titanium oxide film electrode through the hole; and, sealing the thermoplastic polymer.

The redox electrolyte, hole-transport material, or p-type semiconductor may be liquid, a coagulated form(gel and gel phase), solid, etc. The liquid may include those obtained by dissolving redox electrolyte, dissolved salt, hole-transport material, or p-type semiconductor in a solvent, and a room temperature dissolved salt. The coagulated form(gel and gel phase) may include those obtained by including redox electrolyte, a dissolved salt, hole-transport material, or p-type semiconductor in a polymer matrix or low molecular gellant, etc. The solid may include redox electrolyte, a dissolved salt, hole-transport material, or p-type semiconductor.

The hole-transport material may include amine derivatives, conductive polymer such as polyacetylene, polyaniline, polythiophene, etc., or those using discotic liquid crystal phase such as triphenylene. The p-type semiconductor may include Cul, CuSCN, etc. As the counter electrode, those having conductivity and catalytic function on reduction of redox electrolyte may be preferably used, and, for example, those obtained by depositing platinum, carbon, rhodium, ruthenium, etc. on a glass or a polymer film, or applying conductive particles thereon may be used.

The redox electrolyte used in the solar cell of the present invention may include halogen redox electrolyte consisting of halogen compound comprising halogen ion as a counter ion and a halogen molecule, metal redox electrolyte such as ferrocyanide-ferrocyanide or ferrocene-ferricynium ion, metal complex such as cobalt complex, etc., organic redox electrolyte such as alkylthio-alkyldisulfide, viologen dye, hydroquinone-quinone, etc., and halogen redox electrolyte may be preferable. As the halogen molecule comprised in the halogen redox electrolyte, an iodine molecule may be preferable. As the halogen compounds comprising halogen ion as counter ion, a halogenated metal salt such as Lil, Nal, Kl, Cal₂, Mgl₂, Cul, etc., or an organic ammonium salt of halogen such as tetraalkylammonium iodide, imidazolium iodide, pyridium iodide, etc. or l₂ may be used.

In case the redox electrolyte is in the form of a solution comprising the same, an electrochemically inert solvent may be used. For example, acetonitrile, propylenecarbonate, etylenecarbonate, 3-methoxypropionitrile, methoxyacetonitrile, ethyleneglycol, propyleneglycol, diethyleneglycol, triethyleneglycol, butyrolactone, dimethoxyethane, dimethylcarbonate, 1,3-dioxolane, methylformate, 2-methyltetrahydrofurane, 3-methoxy-oxazolidin-2-on, sulforane, tetrahydrofurane, water, etc. may be used, and acetonitrile, propylenecarbonate, ethylenecarbonate, 3-methoxypropionitrile, ethyleglycol, 3-methoxy-oxazolidin-2-on, or butyrolactone may be preferable. These solvent may be used alone or in combination. As a gel phase positive electrolyte, those obtained by including electrolyte or electrolyte solution in oligomer or polymer matrix, or including electrolyte or electrolyte solution in a starch gellant may be used. The concentration of the redox electrolyte may be preferably 0.01 - 99 wt%, and more preferably 0.1 - 30 wt%.

The solar cell of the present invention may be obtained by disposing a photoelectric transformation element(negative electrode) wherein dye is supported on oxide semiconductor particles on a substrate and a counter electrode(positive electrode) opposite thereto, and filling a redox electrolyte containing solution therebetween.

### [Example]

### Synthesis of dye

All the reactions were performed under argon atmosphere, and a solvent was distilled with an appropriate reagent purchased from Sigma-Aldrich Company. 1 H NMR spectrum was measured by Varian Mercury 300 spectrometer. Absorption and emission spectrums were respectively measured by Perkin-Elmer Lambda 2S UV-visible spectrometer and Perkin LS fluorescent spectrometer.

### [Example 1] Synthesis of a compound of the Chemical Formula 1a

(1-1) 2,3-dihydrothieno[3,4-b][1,4]dioxin-5-yl)trimethylstannan (0.40g 1.34mmol), a compound of the Chemical Formula 2a (0.75g, 1.12mmol), and Pd(PPh3)4 (0.065g, 0.056mmol) were dissolved in THF (40ml), and then, refluxed under nitrogen atmosphere for 8 hours. Subsequently, an organic layer was extracted with water and methylene chloride and distilled, and column chromatography was performed (eluent - MC : Hx = 1 : 4) to synthesize a compound of the Chemical Formula 4a.
   ¹H NMR(CDCl3) : [ppm] = 0.96(m, 6H), 1.29(m, 4H), 1.96(m, 4H), 2.55(m, 8H), 2.62(m, 4H), 4.68(s, 2H), 4.71(s, 2H), 6.71(m, 2H), 6.96(s, 1H), 7.08(s, 1H), 7.18(m, 4H), 7.38(m, 2H), 7.45(m, 6H), 7.55(d, 3JHH = 8.8Hz, 2H).
(1-2) The compound of the Chemical Formula 4a (0.87g, 1.2mmol) was dissolved in DMF (20ml), and then, POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 5a.
   ¹H NMR(CDCl3) : [ppm] = 0.96(m, 6H), 1.29(m, 4H), 1.96(m, 4H), 2.55(m, 8H), 2.62(m, 4H), 4.68(s, 2H), 4.71 (s, 2H), 6.71 (m, 2H), 7.08(s, 1H), 7.18(m, 4H), 7.38(m, 2H), 7.45(m, 6H), 7.53(d, 3JHH = 8.8Hz, 2H), 9.54(s, 1H).
(1-3) The compound of the Chemical Formula 5a (0.58g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1a.
   ¹H NMR(DMSO) : [ppm] = 0.96(m, 6H), 1.29(m, 4H), 1.44(s, 12H), 1.96(m, 4H), 2.55(m, 8H), 2.62(m, 4H), 4.68(s, 2H), 4.71 (s, 2H), 6.98(m, 2H), 7.08(s, 1H), 7.2(m, 4H), 7.39(m, 2H), 7.42(m, 6H), 7.53(d, 3JHH = 8.8Hz, 2H), 11.48(s, 1H).

### [Example 2] Synthesis of a compound of the Chemical Formula 1b

(2-1) (2,3-dihydrothieno[3,4-b][1,4]dioxin-5-yl)trimethylstannan (0.40g 1.34mmol), a compound of the Chemical Formula 2b (1 g, 1.12mmol), and Pd(PPh3)4 (0.065g, 0.056mmol) were dissolved in THF (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 4b.
   ¹H NMR(CDCl3) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.91(s, 1H), 6.96(s, 1H), 7.08(s, 1H), 7.18(m, 6H), 7.38(m, 6H), 7.55(m, 4H), 7.82(d, 3JHH = 8.8Hz, 2H).
(2-2) The compound of the Chemical Formula 4b (1.14g, 1.2mmol) was dissolved in DMF (20ml), and then POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 5b.
   ¹H NMR(CDCl3) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.93(s, 1H), 7.08(s, 1H), 7.18(m, 6H), 7.38(m, 6H), 7.55(m, 4H), 7.82(d, 3JHH = 8.8Hz, 2H), 9.51 (s, 1H).
(2-3) The compound of the Chemical Formula 5b (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1 b.
   ¹H NMR(DMSO) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.98(m, 2H), 7.08(s, 1H), 7.15(m, 6H), 7.32(m, 6H), 7.55(m, 4H), 7.80 (d, 3JHH = 8.8Hz, 2H), 11.51 (s, 1H).

### [Example 3] Synthesis of a compound of the Chemical Formula 1e

(3-1) (2,3-dihydrothieno[3,4-b][1,4]dioxin-5-yl)trimethylstannan (0.40g 1.34mmol), 5-bromo-2-(4-(2,2-diphenylvinyl)phenyl)-3-hexylthiophene(a compound of the Chemical Formula 2e (0.67g, 1.34mmol), and Pd(PPh3)4 (0.065g, 0.056mmol) were dissolved in THF (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 4e.
   ¹H NMR(CDCl3) : [ppm] = 0.88(m, 3H), 1.29(m, 2H), 1.86(m, 2H), 2.55(m, 4H), 2.62(m, 2H), 4.68(s, 2H), 4.71 (s, 2H), 6.71 (s, 1H), 6.96(s, 1H), 7.08(s, 1H), 7.18(m, 4H), 7.38(m, 2H), 7.45(m, 6H), 7.55(d, 3JHH = 8.8Hz, 2H).
(3-2) The compound of the Chemical Formula 4e (1.14g, 1.2mmol) was dissolved in DMF (20ml), and then POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 5e.
   ¹H NMR(CDCl3) : [ppm] = 0.92(m, 3H), 1.31(m, 2H), 1.86(m, 2H), 2.58(m, 4H), 2.65(m, 2H), 4.68(s, 2H), 4.73(s, 2H), 6.71 (s, 1H), 6.96(s, 1H), 7.18(m, 4H), 7.42(m, 2H), 7.48(m, 6H), 7.55(d, 3JHH = 8.8Hz, 2H), 9.56(s, 1H).
(3-3) The compound of the Chemical Formula 5e (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1e.
   ¹H NMR(DMSO) : [ppm] = 0.96(m, 3H), 1.29(m, 2H), 1.96(m, 2H), 2.55(m, 4H), 2.62(m, 2H), 4.68(s, 2H), 4.71(s, 2H), 6.98(m, 2H), 7.08(s, 1H), 7.18(m, 4H), 7.42(m, 2H), 7.51 (m, 6H), 7.58(d, 3JHH = 8.8Hz, 2H), 11.54(s, 1H).

### [Example 4] Synthesis of a compound of the Chemical Formula 1f

(4-1) (2,3-dihydrothieno[3,4-b][1,4]dioxin-5-yl)trimethylstannan (0.40g 1.34mmol), N-(4-(5-bromo-3-hexylthiophene-2-yl)phenyl)-N-(9,9-dimethyl-9H-fluorene-2-yl)-9.9-dimethyl-9H-fluorene-2-amine (a compound of the Chemical Formula 2f (0.97g, 1.34mmol), and Pd(PPh3)4 (0.065g, 0.056mmol) were dissolved in THF (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 4f.
   ¹H NMR(CDCl3) : [ppm] = 0.89(m, 3H), 1.29(m, 4H), 1.47(s, 12H), 1.52(m, 4H), 2.52(m, 2H), 4.68(s, 2H), 4.71 (s, 2H), 6.93 (s, 1H), 6.98(s, 1H), 7.09(m, 4H), 7.31 (m, 4H), 7.38(m, 4H), 7.58(d, 3JHH = 11.6Hz, 2H), 7.62.(m, 4H).
(4-2) The compound of the Chemical Formula 4f (1.14g, 1.2mmol) was dissolved in DMF (20ml), and then POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 5f.
   ¹H NMR(CDCl3) : [ppm] = 0.89(m, 3H), 1.29(m, 4H), 1.47(s, 12H), 1.52(m, 4H), 2.52(m, 2H), 4.68(s, 2H), 4.71 (s, 2H), 6.93 (s, 1H), 7.09(m, 4H), 7.31 (m, 4H), 7.38(m, 4H), 7.58(d, 3JHH = 11.6Hz, 2H), 7.62.(m, 4H), 9.51 (s, 1H).
(4-3) The compound of the Chemical Formula 5f (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1f.
   ¹H NMR(DMSO) : [ppm] = 0.96(m, 3H), 1.29(m, 2H), 1.44(s, 12H), 1.96(m, 2H), 2.55(m, 4H), 2.62(m, 2H), 4.68(s, 2H), 4.71(s, 2H), 6.96(s, 1H), 7.08(s, 1H), 7.15(m, 6H), 7.32(m, 6H), 7.55(m, 4H), 7.80 (d, 3JHH = 8.8Hz, 2H), 11.51 (s, 1 H).

### [Example 5] Synthesis of a compound of the Chemical Formula 1n

(5-1) (2,3-dihydrothieno[3,4-b][1,4]dioxin-5-yl)trimethylstannan (0.81g 2.66mmol), N-(4-bromophenyl)-N-(9,9-dimethyl-9H-fluorene-2-yl)-9,9-dimethyl-9H-fluorene-2-amine(a compound of the Chemical Formula 2n) (1.78g, 3.2mmol), and Pd(PPh3)4 (0.15g, 0.13mmol) were dissolved in THF (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 4n.
   ¹H NMR(CDCl3) : [ppm] = 1.47(s, 12H), 4.68(s, 2H), 4.71(s, 2H), 6.98(s, 1H), 7.09(m, 4H), 7.31(m, 4H), 7.38(m, 4H), 7.58(d, 3JHH = 11.6Hz, 2H), 7.62.(m, 4H).
(5-2) The compound of the Chemical Formula 4n (N-(4-(2,3-dihydrothieno[3,4-b][1,4]dioxin-5-yl)phenyl)-N-(9,9-dimethyl-9H-fluore ne-2-yl)-9,9-dimethyl-9H-fluorene-2-amine) (1.84g, 2.98mmol) and N-bromostyrene (0.64g, 3.57mmol) were dissolved in THF 30ml, and then, the reaction mixture was agitated under nitrogen atmosphere. Subsequently, an organic layer was extracted with methylene chloride and water and distilled to obtain N-(4-(7-bromo-2,3-dihydrothieno[3,4-b][1,4]dioxin-5-yl)phenyl)-N-(9,9-dimethyl-9 H-fluorene-2-yl)-9,9-dimethyl-9H-fluorene-2-amine) (a compound of the Chemical Formula 7n). The compound of the Chemical Formula 7n (1.95g, 2.8mmol), 3',4-dihexyl-2,2'-bithiophene-5-ylboronic acid (0.88g, 2.33mmol), K2CO3 (0.64g, 4.66mmol), and Pd(PPh3)4 (0.13g, 0.12mmol) were dissolved in DMF (40ml), and then, the reaction mixture was refluxed under nitrogen atmosphere for 8 hours. Subsequently, an organic layer was extracted with methylenechloride and water and distilled, and column chromatography was performed (eluent - Mc : Hx = 1 : 4) to synthesize a compound of the Chemical Formula 9n.
   ¹H NMR(CDCl3) : [ppm] = 0.98(m, 6H), 1.28(m, 4H), 1.44(s, 12H), 1.96(m, 4H), 2.55(m, 8H), 2.62(m, 4H), 4.64(s, 2H), 4.70(s, 2H), 6.92(s, 1H), 6.96(s, 1H), 7.10(s, 1H), 7.18(m, 6H), 7.38(m, 6H), 7.56(m, 4H), 7.84(d, 3JHH = 8.8Hz, 2H).
(5-3) The compound of the Chemical Formula 9n (N-(4-(7-(3',4-dihexyl-2,2'-bithiophene-5-yl)-2,3-dihydrothieno[3,4-b][1,4]dioxin-5 -yl)phenyl)-N-(9,9-dimethyl-9H-fluorene-2-yl)-9,9-dimethyl-9H-fluorene-2-amine) (1.06g, 1.12mmol) was dissolved in DMF (20ml), and then, POCl3 (0.13ml 1.44mmol) was slowly added at 0°C, and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 10n.
   ¹H NMR(CDCl3) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.93(s, 1H), 7.08(s, 1H), 7.18(m, 6H), 7.38(m, 6H), 7.55(m, 4H), 7.82(d, 3JHH = 8.8Hz, 2H). 9.54(s, 1H).
(5-4) The compound of the Chemical Formula 10n (5'-(7-(4-bis(9,9-dimethyl-9H-fluorene-2-yl)amino)phenyl)-2,3-dihydrothieno[3,4-b][1,4]dioxin-5-yl)-3,4'-dihexyl-2,2'-bithiophene-5-carbaldehyde)(0.75g, 0.77mmol), cyanoacetic acid (0.08g, 0.93mmol), and piperidine (0.92ml, 0.93mmol) were dissolved in acetonitrile (20ml), and then the reaction mixture was agitated under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1 n.
   ¹H NMR(DMSO) : [ppm] = 0.94(m, 6H), 1.28(m, 4H), 1.42(s, 12H), 1.98(m, 4H), 2.56(m, 8H), 2.62(m, 4H), 4.68(s, 2H), 4.74(s, 2H), 6.98(m, 2H), 7.11 (s, 1H), 7.20(m, 6H), 7.34(m, 6H), 7.56(m, 4H), 7.82 (d, 3JHH= 8.8Hz, 2H), 11.54(s, 1H).

### [Example 6] Synthesis of a compound of the Chemical Formula 1r

(6-1) (2,3-dihydrothieno[3,4-b][1,4]dioxin-5-yl)trimethylstannan (0.81 g 2.66mmol), 1-bromo-4-(2,2-diphenylvinyl)benzene (a compound of the Chemical Formula 2r) (1.7g, 3.2mmol), and Pd(PPh3)4 (0.15g, 0.13mmol) were dissolved in toluene (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 4r.
   ¹H NMR(CDCl3) : [ppm] = 4.68(s, 2H), 4.72(s, 2H), 6.71(s, 1H), 6.96(s, 1H), 7.08(s, 1H), 7.18(m, 4H), 7.40(m, 2H), 7.48(m, 6H), 7.56(d, 3JHH = 8.8Hz, 2H).
(6-2) The compound of the Chemical Formula 4r (5-(4-(2,2-diphenylvinyl)phenyl-2,3-dihydrothieno[3,4-b][1,4]dioxin) (1.18g, 3.00mmol) and N-bromostyrene (0.64g, 3.57mmol) were dissolved in THF 30ml, and then, the reaction mixture was agitated under nitrogen atmosphere. Subsequently, an organic layer was extracted with methylene chloride and water and distilled to obtain 5-bromo-7-(4-(2,2-diphenylvinyl)phenyl)-2,3-dihydrothieno[3,4-b][1,4]dioxin (a compound of the Chemical Formula 7r) (1.33g, 2.8mmol). The compound of the Chemical Formula 7r (1.33g, 2.8mmol), 3',4-dihexyl-2,2'-bithiophene-5-ylboronic acid (0.88g, 2.33mmol), K2CO3 (0.64g, 4.66mmol), and Pd(PPh3)4 (0.13g, 0.12mmol) were dissolved in DMF (40ml), and then refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 9r.
   ¹H NMR(CDCl3) : [ppm] = 0.96(m, 6H), 1.29(m, 4H), 1.96(m, 4H), 2.55(m, 8H), 2.62(m, 4H), 4.68(s, 2H), 4.71 (s, 2H), 6.71 (m, 2H), 6.96(s, 1H), 7.08(s, 1H), 7.18(m, 4H), 7.38(m, 2H), 7.45(m, 6H), 7.55(d, 3JHH = 8.8Hz, 2H).
(6-3) The compound of the Chemical Formula 9r (5-(3',4-dihexyl-2,2'-bithiophene-5-yl)-7-(4-(2,2-diphenylvinyl)phenyl)-2,3-dihydr othieno[3,4-b][1,4]dioxin) (0.87g, 1.2mmol) was dissolve din DMF (20ml), and then, POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 10r.
   ¹H NMR(CDCl3) : [ppm] = 0.96(m, 6H), 1.29(m, 4H), 1.96(m, 4H), 2.55(m, 8H), 2.62(m, 4H), 4.68(s, 2H), 4.71(s, 2H), 6.72(m, 2H), 7.10(s, 1H), 7.18(m, 4H), 7.38(m, 2H), 7.45(m, 6H), 7.54(d, 3JHH = 8.8Hz, 2H), 9.54(s, 1H).
(6-4) The compound of the Chemical Formula 10r (5-(7-(4-(2,2-diphenylvinyl)phenyl)-2,3-dihydrothieno[3,4-b][1,4]dioxin-5-yl)-3',4-dihexyl-2,2'-bithiophene-5-carbaldehyde) (0.58g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1r.
   ¹H NMR(DMSO) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.98(m, 2H), 7.08(s, 1H), 7.2(m, 4H), 7.39(m, 2H), 7.42(m, 6H), 7.53(d, 3JHH = 8.8Hz, 2H), 11.48(s, 1H).

### [Example 7] Synthesis of a compound of the Chemical Formula 1q

(7-1) The compound of the Chemical Formula 7r obtained in the Example 6, (6-2) (1.2g, 2.52mmol), 3-hexylthiophene-2-ylboronic acid (0.44g, 2.1mmol), K2CO3 (0.58g, 4.2mmol), and Pd(PPh3)4 (0.12g, 0.105mmol) were dissolved in DMF (30ml), and then, the reaction mixture was refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 9r'.
   ¹H NMR(CDCl3) : [ppm] = 0.88(m, 3H), 1.29(m, 2H), 1.86(m, 2H),2.55(m, 4H), 2.62(m, 2H), 4.64(s, 2H), 4.70(s, 2H), 6.72(s, 1H), 6.96(s, 1H), 7.08(s, 1H), 7.18(m, 4H), 7.38(m, 2H), 7.44(m, 6H), 7.54(d, 3JHH = 8.8Hz, 2H).
(7-2) The compound of the Chemical Formula 9r' (5-(4-(2,2-diphenylvinyl)phenyl)-7-(3-hexylthiophene-2-yl)-2,3-dihydrothieno[3,4-b][1,4]dioxin) (0.98g, 1.2mmol) was dissolved in DMF (20ml), and then, POCl3 (0.13ml 1.44mmol) was slowly added at 0°C and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 10r'.
   ¹H NMR(CDCl3) : [ppm] = 0.88(m, 3H), 1.30(m, 2H), 1.86(m, 2H), 2.58(m, 4H), 2.65(m, 2H), 4.68(s, 2H), 4.73(s, 2H), 6.71 (s, 1H), 6.96(s, 1H), 7.18(m, 4H), 7.42(m, 2H), 7.50(m, 6H), 7.56(d, 3JHH = 8.8Hz, 2H), 9.58(s, 1H).
(7-3) The compound of the Chemical Formula 10r' (5-(7-(4-(2,2-diphenylvinyl)phenyl)-2,3-dihydrothieno[3,4-b][1,4]dioxin-5-yl)-4-he xylthiophene-2-carbaldehyde) (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA : EtOH = 10 : 1) to synthesize a compound of the Chemical Formula 1q.
   ¹H NMR(DMSO) : [ppm] = 0.94(m, 3H), 1.29(m, 2H), 1.95(m, 2H), 2.56(m, 4H), 2.64(m, 2H), 4.68(s, 2H), 4.72(s, 2H), 6.98(m, 2H), 7.11 (s, 1H), 7.20(m, 4H), 7.42(m, 2H), 7.51 (m, 6H), 7.58(d, 3JHH = 8.8Hz, 2H), 11.54(s, 1H).

### [Example 8] Synthesis of a compound of the Chemical Formula 1m

(8-1) The compound of Chemical Formula 7n obtained in the Example 5, (5-2) (1.92g, 1.34mmol), 3-hexylthiophene-2-ylboronic acid (0.28g, 1.34mmol), K2CO3 (0.64g, 4.66mmol), and Pd(PPh3)4 (0.13g, 0.12mmol) were dissolved in DMF (40ml), and then, the reaction mixture was refluxed under nitrogen atmosphere for 8 hours. Subsequently, an organic layer was extracted with methylene chloride and water and distilled, and column chromatography was performed (eluent - MC : Hx = 1 : 4) to synthesize a compound of the Chemical Formula 9n'.
   ¹H NMR(CDCl3) : [ppm] = 0.89(m, 3H), 1.29(m, 4H), 1.47(s, 12H), 1.52(m, 4H), 2.52(m, 2H), 4.68(s, 2H), 4.71 (s, 2H), 6.93 (s, 1H), 6.98(s, 1H), 7.09(m, 4H), 7.31 (m, 4H), 7.38(m, 4H), 7.58(d, 3JHH = 11.6Hz, 2H), 7.62.(m, 4H).
(8-2) The compound of the Chemical Formula 9n' (N-(9,9-dimethyl-9H-fluorene-2-yl)-N-(4-(7-(3-hexylthiophene-2-yl)-2,3-dihydroth ieno[3,4-b][1,4]dioxin-5-yl)phenyl)-9,9-dimethyl-9H-fluorene-2-amine) (0.88g, 1.12mmol) was dissolved in DMF (20ml), and then, POCl3 (0.13ml 1.44mmol) was slowly added at 0°C and the reaction mixture was agitated at 80°C for 4 hours. After agitation, an organic layer was extract with methylene chloride and water and distilled, and column chromatography was performed (eluent - EA : Hx = 1 : 2) to synthesize a compound of the Chemical Formula 10n'.
   ¹H NMR(CDCl3) : [ppm] = 0.89(m, 3H), 1.29(m, 4H), 1.47(s, 12H), 1.52(m, 4H), 2.52(m, 2H), 4.68(s, 2H), 4.74(s, 2H), 6.94 (s, 1H), 7.12(m, 4H), 7.32(m, 4H), 7.40(m, 4H), 7.56(d, 3JHH = 11.6Hz, 2H), 7.62.(m, 4H), 9.54(s, 1H).
(8-3) The compound of the Chemical Formula 10n' (5-(7-(4-(bis(9,9-dimehtyl-9H-fluorene-2-yl)amino)phenyl)-2,3-dihydrothieno[3,4-b][1,4]dioxin-5-yl)-4-hexylthiophene-5-carbaldehyde) (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and then, column chromatography was performed (eluent - EA : EtOH = 10 : 1) to synthesize a compound of the Chemical Formula 1n.
   ¹H NMR(DMSO) : [ppm] = 0.96(m, 3H), 1.29(m, 2H), 1.44(s, 12H), 1.96(m, 2H), 2.55(m, 4H), 2.62(m, 2H), 4.68(s, 2H), 4.71(s, 2H), 6.98(s, 1H), 7.11 (s, 1H), 7.20(m, 6H), 7.42(m, 6H), 7.58(m, 4H), 7.80 (d, 3JHH = 8.8Hz, 2H), 11.52(s, 1H).

### [Example 9] Synthesis of a compound of the Chemical Formula 1w

### (9-1) The compound of the Chemical Formula 4e obtained in the Example 3

(3-1) (5-(5-(4-(2,2-diphenylvinyl)phenyl)-4-hexylthiophene-2-yl)-2,3-dihydrothieno[3,4-b][1,4]dioxin)) (1.2g, 2.13mmol) and N-bromostyrene (0.45g, 2.56mmol) were dissolved in THF 30ml, and then, the reaction mixture was agitated under nitrogen atmosphere for 4 hours. Subsequently, an organic layer was extract with methylene chloride and water and distilled to obtain 5-bromo-7-(5-(4-(2,2-diphenylvinyl)phenyl)-4-hexylthiophene-2-yl)-2,3-dihydrothi eno[3,4-b][1,4]dioxin (a compound of the Chemical Formula 7w). The compound of the Chemical Formula 7w (1.15g, 1.8mmol), 3-hexylthiophene-2-ylboronic acid (0.32g, 1.5mmol), K2CO3 (0.42g, 3mmol), and Pd(PPh3)4 (0.086g, 0.075mmol) were dissolved in DMF (30ml), and then, the reaction mixture was refluxed under nitrogen atmosphere for 8 hours. Subsequently, an organic layer was extracted with methylene chloride and water and distilled, and column chromatograph was performed (eluent - MC : Hx = 1 : 4) to synthesize a compound of the Chemical Formula 9w.
   ¹H NMR(CDCl3) : [ppm] = 0.94(m, 6H), 1.28(m, 4H), 1.44(s, 12H), 1.98(m, 4H), 2.55(m, 8H), 2.64(m, 4H), 4.64(s, 2H), 4.72(s, 2H), 6.72(m, 2H), 6.98(s, 1H), 7.10(s, 1H), 7.20(m, 4H), 7.40(m, 2H), 7.48(m, 6H), 7.55(d, 3JHH = 8.8Hz, 2H).
(9-2) The compound of the Chemical Formula 9w (5-(5-(4-(2,2-diphenylvinyl)phenyl)-4-hexylthiophene-2-yl)-7-(3-hexylthiophene-2 -yl)-2,3-dihydrothieno[3,4-b][1,4]dioxin) (1.14g, 1.2mmol) was dissolved in DMF (15ml), and then, POCl3 (0.13ml 1.44mmol) was slowly added at 0°C, and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 10w.
   ¹H NMR(CDCl3) : [ppm] = 0.94(m, 6H), 1.29(m, 4H), 1.44(s, 12H), 1.98(m, 4H), 2.55(m, 8H), 2.64(m, 4H), 4.64(s, 2H), 4.72(s, 2H), 6.71(m, 2H), 7.18(m, 5H), 7.38(m, 2H), 7.45(m, 6H), 7.53(d, 3JHH = 8.8Hz, 2H), 9.54(s, 1H).
(9-3) The compound of the Chemical Formula 10w (5-(7-(5-(4-(2,2-diphenylvinyl)phenyl)-4-hexylthiophene-2-yl)-2,3-dihydrothieno[3 ,4-b][1,4]dioxin-5-yl)-4-hexylthiophene-2-carbadaldehyde) (1.05g, 0.8mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methylene chloride and water and distilled, and column chromatography was performed (eluent - EA :EtOH = 10 : 1) to synthesize a compound of the Chemical Formula 1w.
   ¹H NMR(DMSO) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.98(m, 2H), 7.06(s, 1H), 7.20(m, 6H), 7.36(m, 6H), 7.52(m, 4H), 7.84 (d, 3JHH = 8.8Hz, 2H), 11.50(s, 1H).

### [Example 10] Synthesis of a compound of the Chemical Formula 1u

(10-1) The compound of the Chemical Formula 4f obtained in the Example 4 (4-1) (N-(4-(5-(2,3-dihydrothieno[3,4-b][1,4]dioxin-5-yl)-3-hexylthiophene-2-yl)phenyl )-N-(9,9-dimethyl-9H-fluorene-2-yl)-9,9-dimethyl-9H-fluorene-2-amine) (1.64g, 2.10mmol) and N-bromostyrene (0.44g, 2.54mmol) were dissolved in THF 30ml, and then, the reaction mixture was agitated under nitrogen atmosphere for 4 hours. Subsequently, an organic layer was extracted with methylene chloride and water and distilled to obtain N-(4-(5-(7-bromo-2,3-dihydrothieno[3,4-b][1,4]dioxin-5-yl)-3-hexylthiophene-2-yl)phenyl)-N-(9,9-dimethyl-9H-fluorene-2-yl)-9,9-dimethyl-9H-fluorene-2-amine (a compound of the Chemical Formula 7u). The compound of the Chemical Formula 7u (1.53g, 1.78mmol), 3-hexylthiophene-2-ylboronic acid (0.32g, 1.5mmol), K2CO3 (0.42g, 3mmol), and Pd(PPh3)4 (0.086g, 0.075mmol) were dissolved in DMF (30ml), and then, the reaction mixture was refluxed under nitrogen atmosphere for 8 hours. Subsequently, an organic layer was extracted with methlyene chloride and water and distilled, and column chromatography was performed (eluent - MC : Hx = 1 : 4) to synthesize a compound of the Chemical Formula 9u.
   ¹H NMR(CDCl3) : [ppm] = 0.94(m, 6H), 1.28(m, 4H), 1.44(s, 12H), 1.96(m, 4H), 2.55(m, 8H), 2.62(m, 4H), 4.68(s, 2H), 4.71 (s, 2H), 6.90(s, 1H), 6.98(s, 1H), 7.10(s, 1H), 7.20(m, 6H), 7.40(m, 6H), 7.56(m, 4H), 7.84(d, 3JHH = 8.8Hz, 2H).
(10-2) The compound of the Chemical Formula 9u (N-(9,9-dimethyl-9H-fluorene-2-yl)-N-(4-(3-hexyl-5-(7-(3-heyxlthiophene-2-yl)-2, 3-dihydrothieno[3,4-b][1,4]dioxin-5-yl)thiophene-2-yl)phenyl)-9,9-dimethyl-9H-flu orene-2-amine) (1.14g, 1.2mmol) was dissolved in DMF (20ml), and then, POCl3 (0.13ml 1.44mmol) was slowly added at 0°C, and the reaction mixture was agitated at 80°C for 4 hours. After agitation, an organic layer was extracted with methylene chloride and water and distilled, and column chromatography was performed (eluent - EA : Hx = 1 : 2) to synthesize a compound of the Chemical Formula 10u.
   ¹H NMR(CDCl3) : [ppm] = 0.96(m, 6H), 1.29(m, 4H), 1.44(s, 12H), 1.96(m, 4H), 2.55(m, 8H), 2.62(m, 4H), 4.68(s, 2H), 4.71 (s, 2H), 6.93(s, 1H), 7.08(s, 1H), 7.18(m, 6H), 7.38(m, 6H), 7.55(m, 4H), 7.82(d, 3JHH = 8.8Hz, 2H). 9.51(s, 1H).
(10-3) The compound of the Chemical Formula 10u (5-(7-(5-(4-(bis(9,9-dimethyl-9H-fluorene-2-yl)amino)phenyl)-4-hexylthiophene-2 -yl)-2,3-dihydrothieno[3,4-b][1,4]dioxin-5-yl)-4-hexylthiophene-2-carbaldehyde) (0.75g, 0.77mmol), cyanoacetic acid (0.08g, 0.93mmol), and piperidine (0.92ml, 0.93mmol) were dissolved in acetonitrile (20ml), and then, the reaction mixture was refluxed under nitrogen atmosphere for 4 hours. Subsequently, an organic layer was extracted with methlyene chloride and water and distilled, and column chromatography was performed (eluent - EA : EtOH = 10 : 1) to synthesize a compound of the Chemical Formula 1u.
   ¹H NMR(DMSO) : [ppm] = 0.96(m, 6H), 1.29(m, 4H), 1.44(s, 12H), 1.96(m, 4H), 2.55(m, 8H), 2.62(m, 4H), 4.68(s, 2H), 4.71(s, 2H), 6.98(m, 2H), 7.08(s, 1H), 7.15(m, 6H), 7.32(m, 6H), 7.55(m, 4H), 7.80 (d, 3JHH = 8.8Hz, 2H), 11.51 (s, 1H).

### [Example 11] Manufacture and Measurement of physical properties of dye-sensitized solar cell

To evaluate current-voltage properties of a dye compound, a solar cell was manufactured using a TiO2 transparent film with a thickness of 7 or 8 µm. A TiO2 paste(Solaronix, 13nm paste) was screen-printed to prepare a TiO2 transparent film with thickness of 7 or 8 µm. The TiO2 film was treated with a 40mM TiCl4 solution and dried at 500 °C for 30 minutes. The treated film was cooled to 60°C, and then, impregnated with each solution of the dye compounds 1a, 1b, 1e and 1f of the present invention prepared in the Example 1 to 4 (0.3 mM dye in 10 mM mixture of ethanol and methylene chloride containing kenodioxycholic acid (MC:EtOH=1:1)) (for compounds 1 a and 1 b, 7 µm TiO2 transparent film, for compounds 1e and 1fm, 8 µm TiO2 transparent film). Between the dye-absorbed TiO2 electrode and a Platinum-counter electrode, a high temperature melting film Surlyn 1702, thickness of 25 µm) was placed as a spacer and heated to assemble a sealed sandwich cell. An electrolyte solution obtained by dissolving 0.6 M of 3-hexyl-1,2-dimethylimidazolium iode, 0.04 M I2, 0.025 M Lil and 0.28 M tert-butylpyridine in acetonitrile was used.

Photoelectrochemical characteristics of the solar cell prepared using each of the dye compounds 1a, 1b,1e and 1f of the present invention were measured and shown in the following Table 1. The photoelectrochemical characteristics of the solar cell were measured by Keithley M 236 source measurement unit, and as a light source, a 300 W Xe lamp equipped with an AM 1.5 filter(Oriel) was used, and the size of the electrode was set to 0.4 x 0.4 cm², and light intensity was set to 1 sun(100 mW/cm²). Light intensity was controlled using an Si solar cell.

**[Table 1]**

| | Voc (V) | Jsc (mA/cm²) | FF (%) | Photoelectric Transformation Efficiency (%) |
|---|---|---|---|---|
| Compound 1a | 0.6769 | 12.547 | 64.56 | 5.48 |
| Compound 1b | 0.688 | 15.09 | 69.4 | 7.2 |
| Compound 1e | 0.605 | 6.54 | 69.62 | 2.75 |
| Compound 1f | 0.5936 | 6.791 | 68.44 | 2.76 |

In the Table 1, J_{sc} indicates short-circuit photocurrent density, Voc indicates open circuit photovoltage, and FF indiates fill factor.

The dye compound of the present invention, when used for a dye-sensitized solar cell(DSSC), shows improved molar absorption coefficient, J_{sc}(short circuit photocurrent density) and photoelectric transformation efficiency, compared to dyes of the prior art, thus largely improving solar cell efficiency, and it may be purified without expensive column thus remarkably lowering dye synthesis cost.

## Claims

1. Organic dye represented by the following Chemical Formula 1: 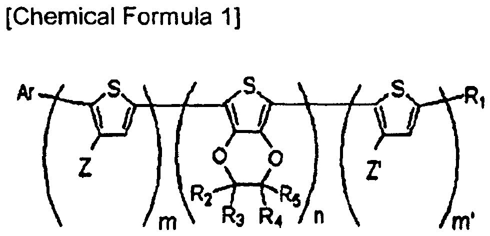 Wherein
R1 is or 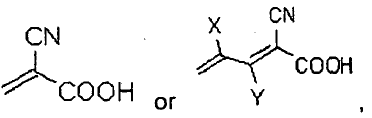 X and Y are independently hydrogen or C1-6 alkyl;
R2 to R5 are independently hydrogen, substituted or unsubstituted C1-30 alkyl or C1-30 alkoxy;
Ar is 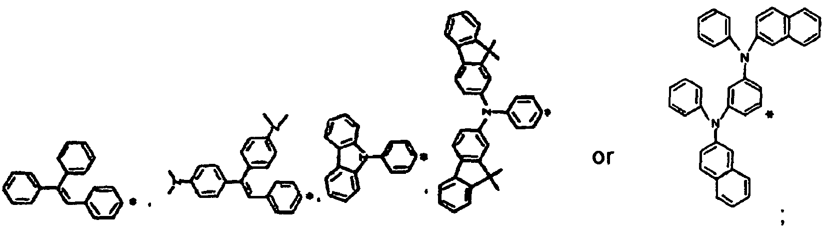
Z and Z' are hexyl;
n is an integer of from 1 to 10;
m and m' are independently an integer of from 0 to 5, provided that both m and m' are not simultaneously 0.

2. The organic dye according to claim 1, wherein the dye is represented by one of the following Chemical Formulae 1a to 1x:

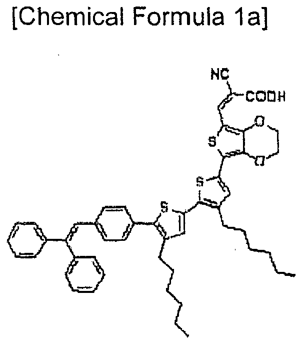

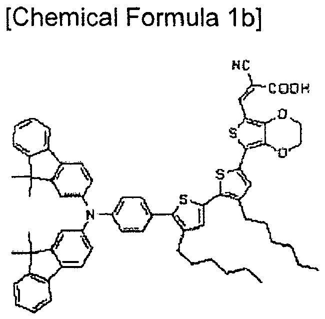

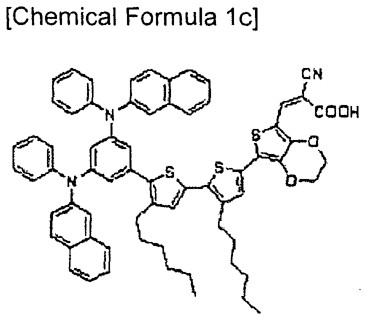

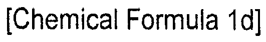

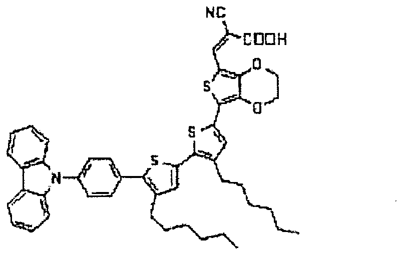

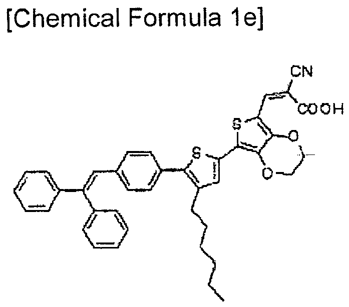

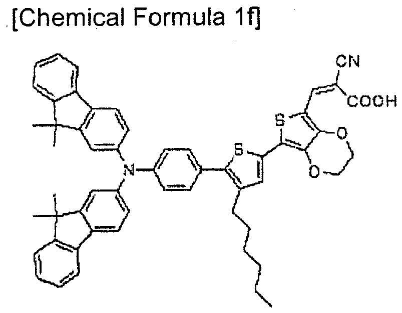

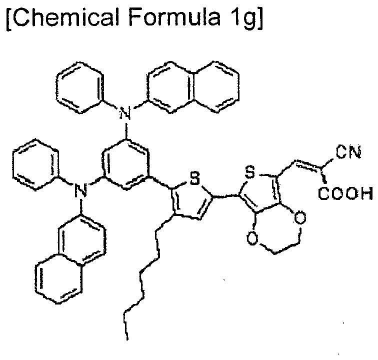

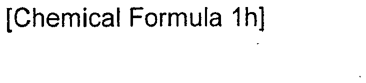

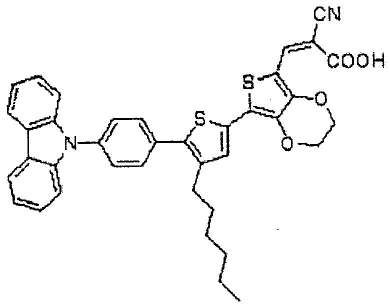

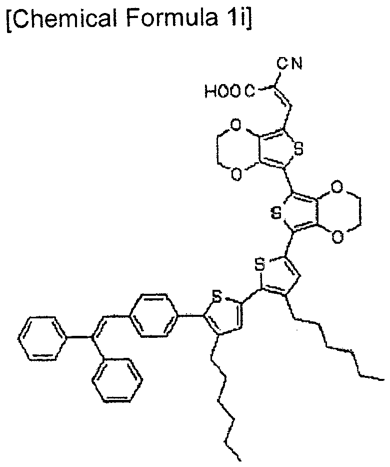

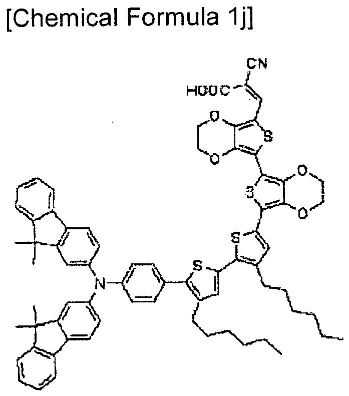

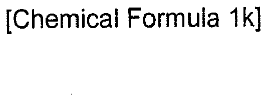

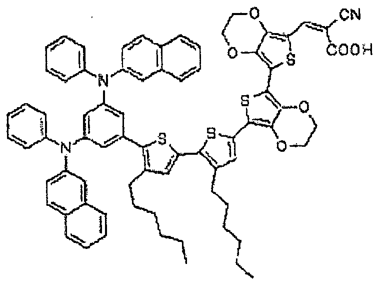

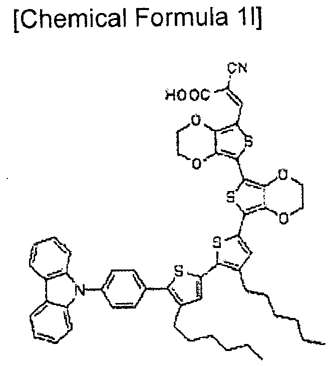

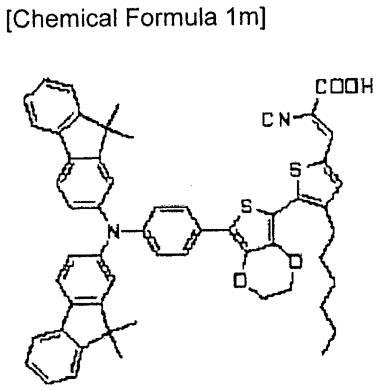

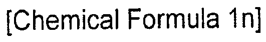

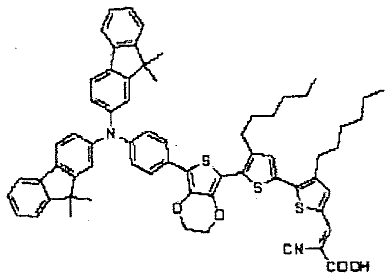

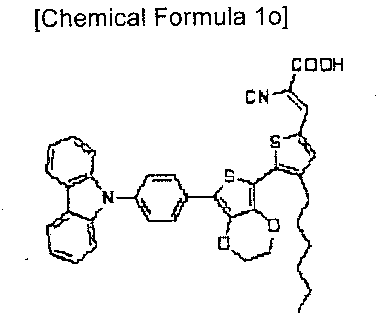

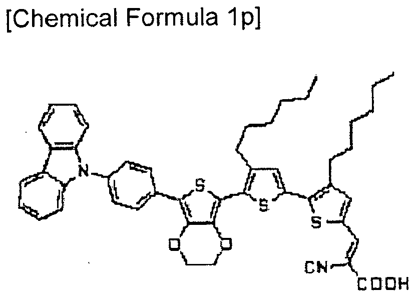

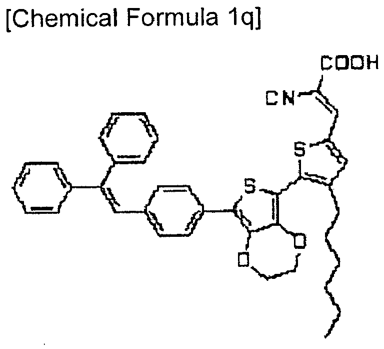

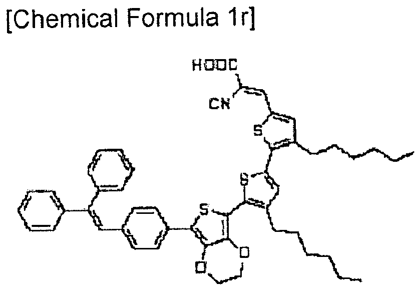

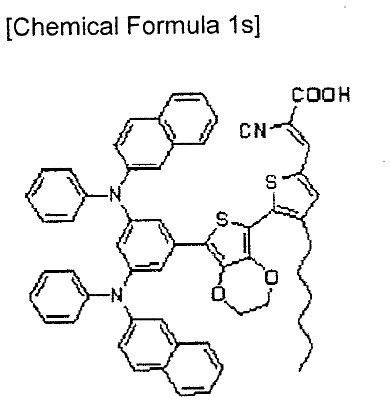

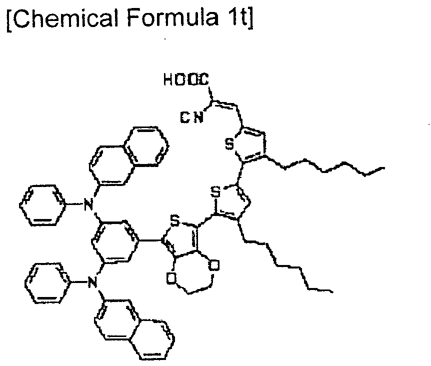

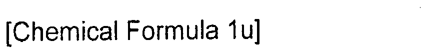

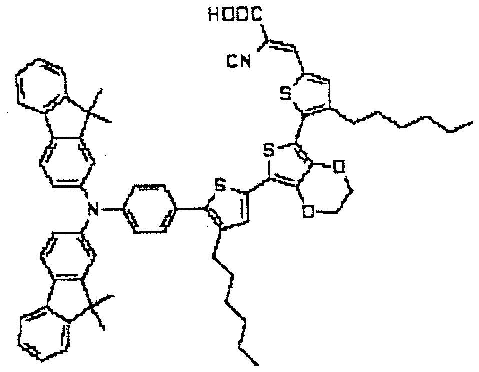

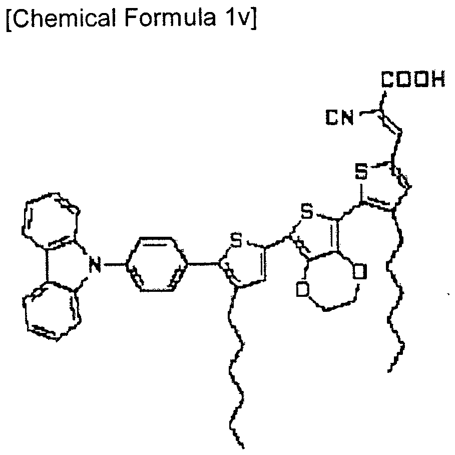

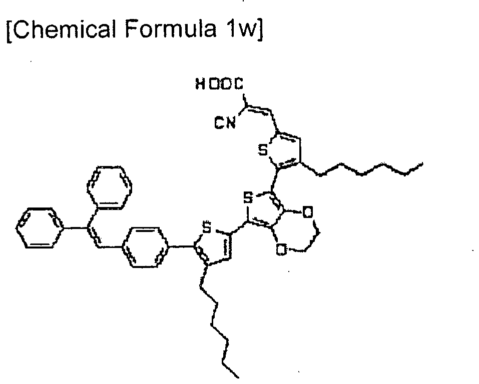

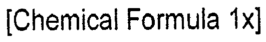

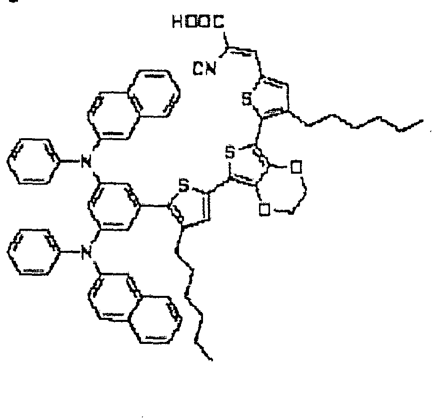

3. A method for preparing organic dye of the following Chemical Formula 1-1 comprising:
(1) preparing a compound of the following Chemical Formula 4 by Suzuki coupling reaction of a compound of the following Chemical Formula 2 with a compound of the following Chemical Formula 3,
(2) preparing a compound of the following Chemical Formula 5 by reacting the compound of the Chemical Formula 4 with POCl₃ in an organic solvent,
(3) reacting the compound of the Chemical Formula 5 with cyanoacetic acid or a compound of the following Chemical Formula 6 in CH₃CN in the presence of piperidine: 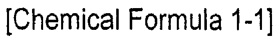 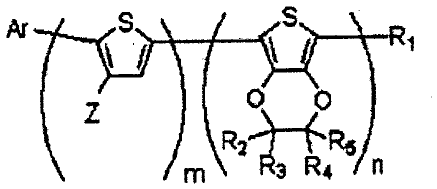 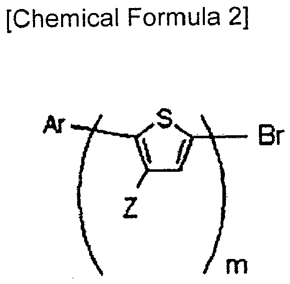 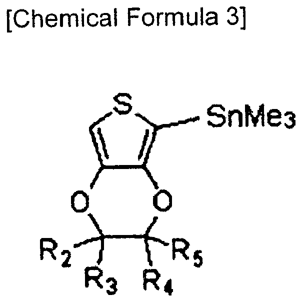 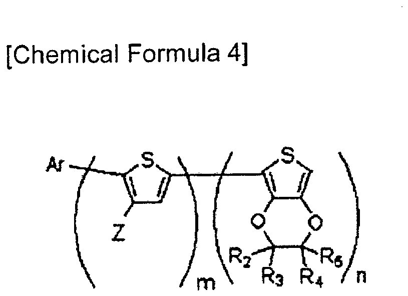 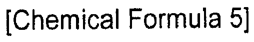 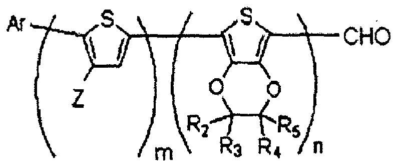 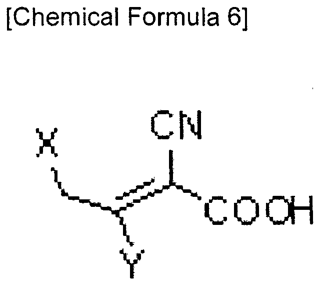 (wherein X, Y, R1 to R5, Ar, Z, m and n are as defined in claim 1)

4. A method for preparing organic dye of the following Chemical Formula 1-2 comprising:
(i) preparing a compound of the following Chemical Formula 4 by Suzuki coupling reaction of a compound of the following Chemical Formula 2 with a compound of the following Chemical Formula 3,
(ii) preparing a compound of the following Chemical Formula 7 by reacting the compound of the Chemical Formula 4 with N-bromostyrene in an organic solvent,
(iii) preparing a compound of the following Chemical Formula 9 by Suzuki coupling reaction of the compound of the Chemical Formula 7 with a compound of the following Chemical Formula 8,
(iv) preparing a compound of the following Chemical Formula 10 by reacting the compound of the Chemical Formula 9 with POCl₃ in an organic solvent, and
(v) reacting the compound of the Chemical Formula 10 with cyanoacetic acid or a compound of the following Chemical Formula 6 in CH₃CN in the presence of piperidine: 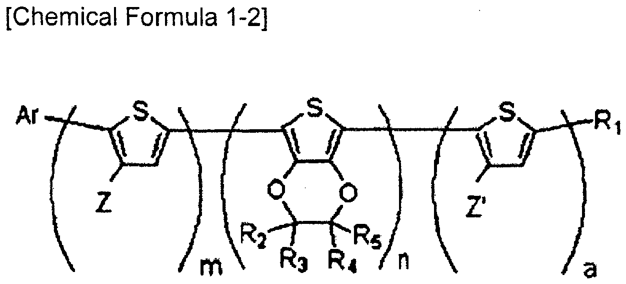 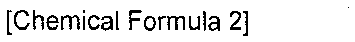 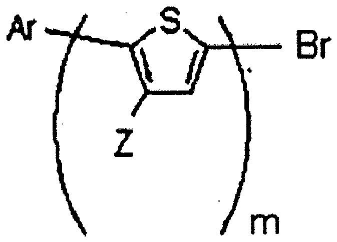 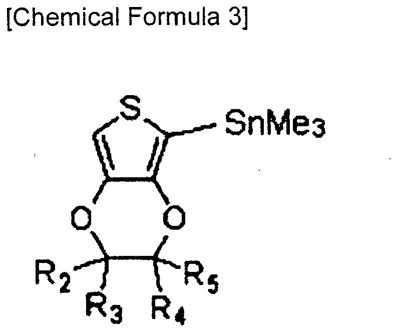 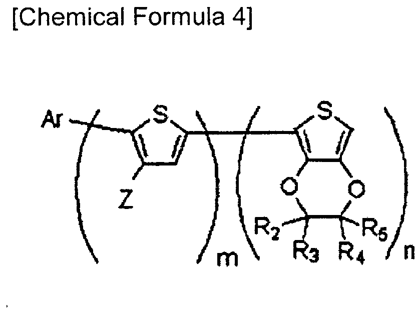 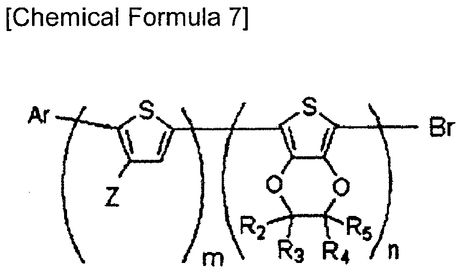 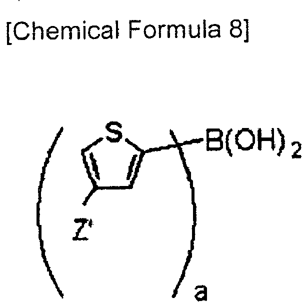 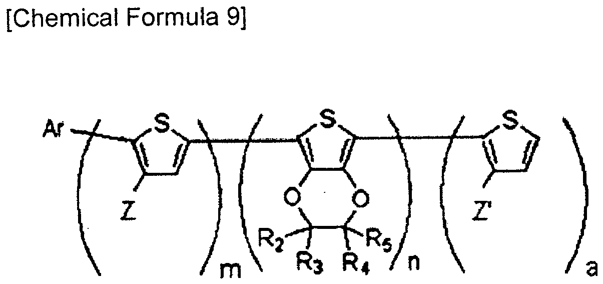 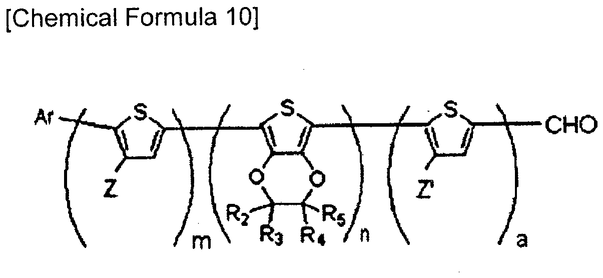 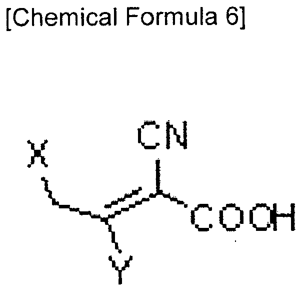 (wherein X, Y, R1 to R5, Ar, Z, Z', m and n are as defined in claim 1)

5. A dye-sensitized photoelectric transformation element comprising oxide semiconductor particles where the organic dye of claim 1 is supported.

6. The dye-sensitized photoelectric transformation element according to claim 5, wherein the organic dye is supported in the oxide semiconductor particles in the presence of an inclusion compound.

7. The dye-sensitized photoelectric transformation element according to claim 5, wherein the oxide semiconductor particles essentially comprise titanium dioxide.

8. The dye-sensitized photoelectric transformation element according to claim 5, wherein the oxide semiconductor particle has an average particle diameter of 1 - 500 nm.

9. A dye-sensitized solar cell comprising the dye-sensitized photoelectric transformation element of claim 5 as an electrode.

10. The dye-sensitized solar cell according to claim, wherein the dye-sensitized solar cell is prepared by coating titanium oxide paste on a transparent conductive substrate; sintering the coated substrate to form a titanium oxide thin film; immersing the substrate having titanium oxide thin film formed thereon in a mixed solution in which the dye represented by the Chemical Formula 1 is dissolved, so as to form a dye-absorbed titanium oxide film electrode; providing a second glass substrate having a counter electrode formed thereon; forming a hole penetrating the second glass substrate and the counter electrode; placing a thermoplastic polymer film between the counter electrode and the dye-absorbed titanium oxide film electrode and heat-pressing them to join the counter electrode and the titanium oxide film electrode; injecting electrolyte into the thermoplastic polymer film placed between the counter electrode and the titanium oxide film electrode through the hole; and, sealing the thermoplastic polymer.

## Patentansprüche

1. Organischer Farbstoff, der durch die folgende chemische Formel 1 dargestellt ist: 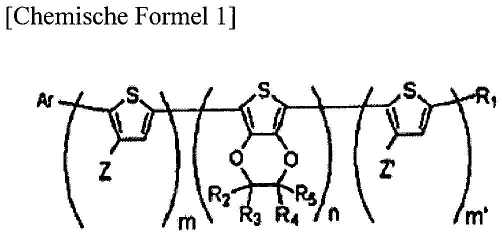 wobei
R1 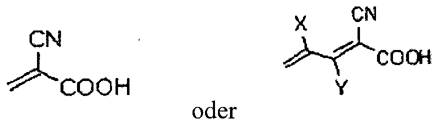 ist, X und Y unabhängig Wasserstoff oder C1-6 alkyl sind;
R2 bis R5 unabhängig Wasserstoff, substituiertes oder unsubstituiertes C1-30 alkyl oder C1-30 alkoxy sind;
Ar 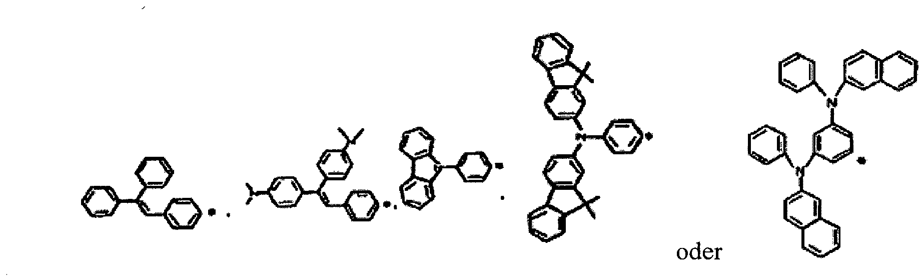 ist;
Z und Z' hexyl sind;
n eine ganze Zahl von 1 bis 10 ist;
m und m' unabhängig eine ganze Zahl von 0 bis 5 sind, vorausgesetzt, dass sowohl m als auch m' nicht gleichzeitig 0 sind.

2. Organischer Farbstoff gemäß Anspruch 1, wobei der Farbstoff durch einen der folgenden chemischen Formeln 1a bis 1x dargestellt ist:

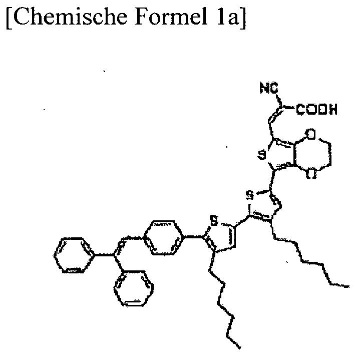

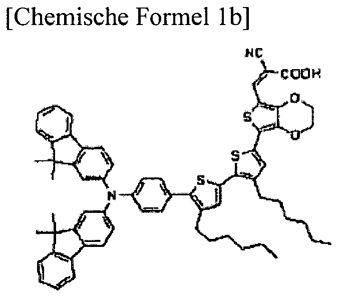

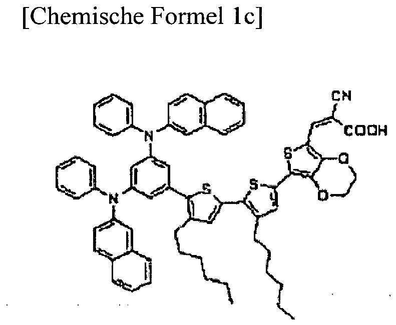

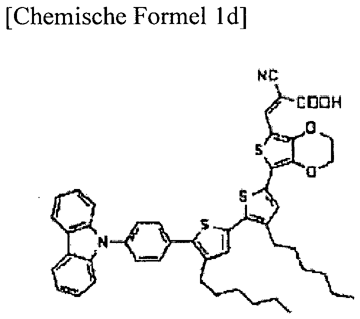

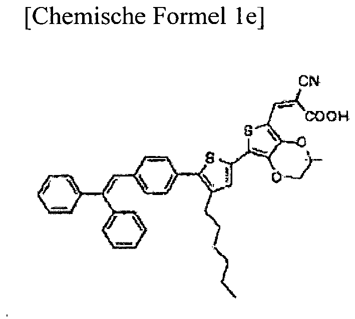

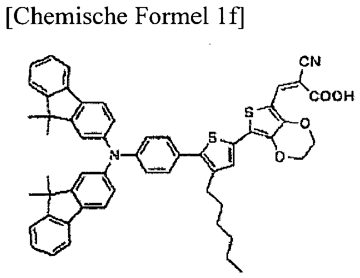

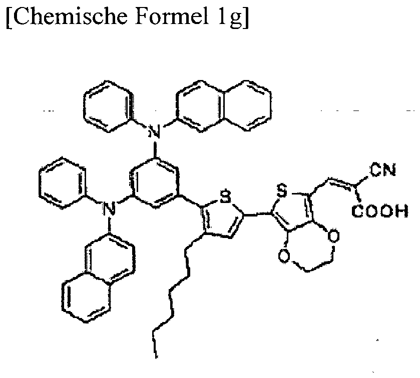

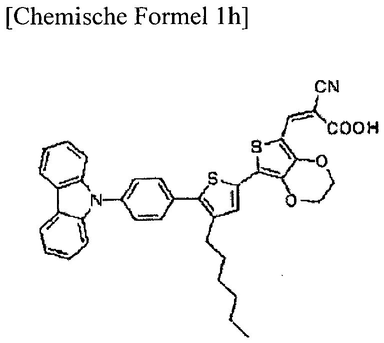

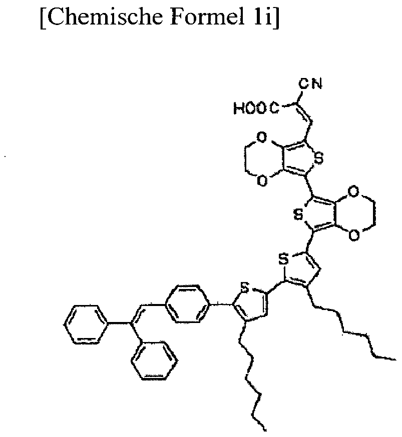

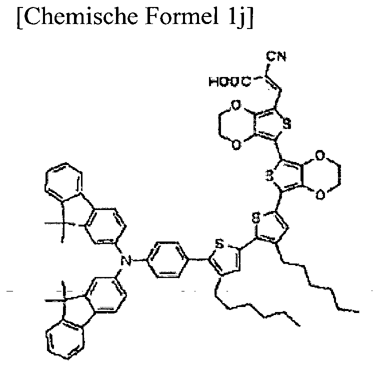

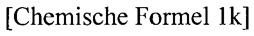

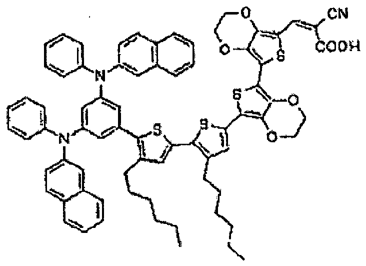

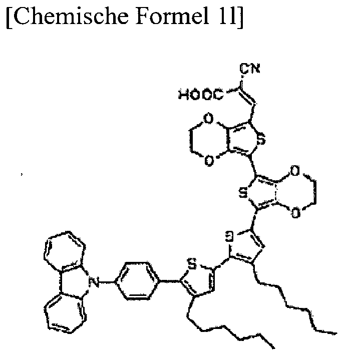

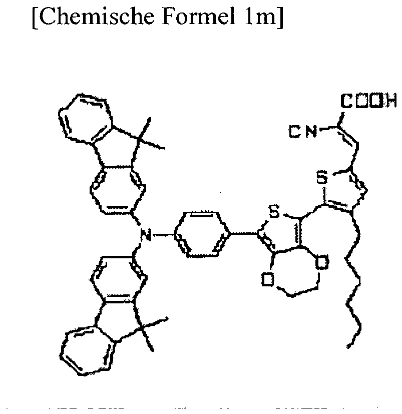

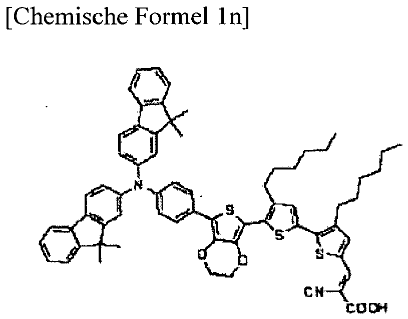

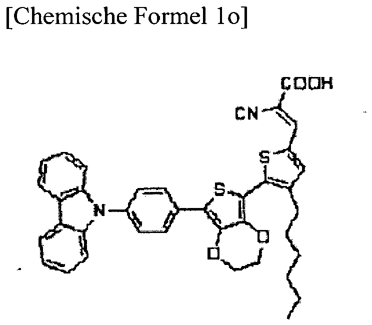

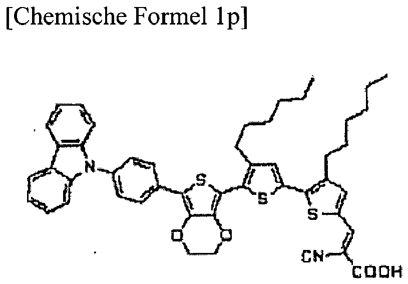

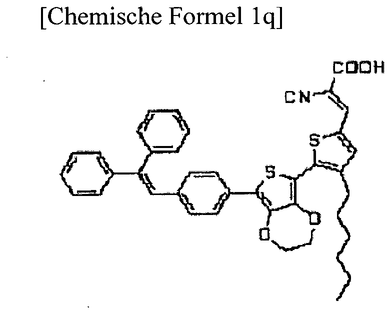

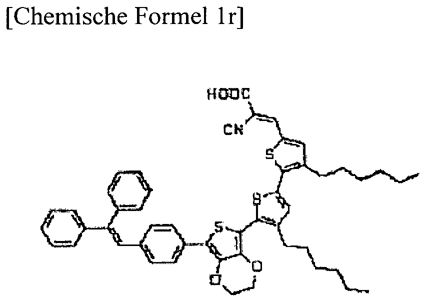

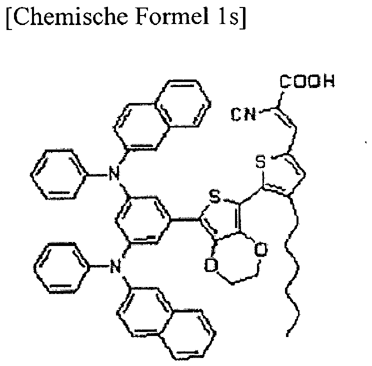

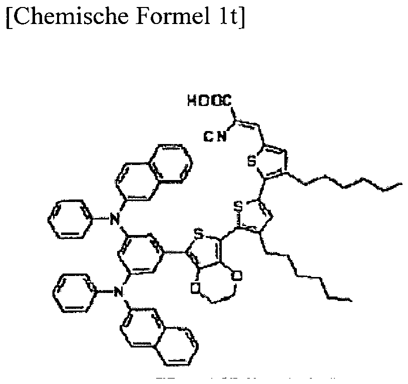

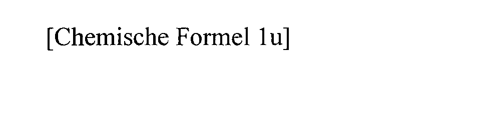

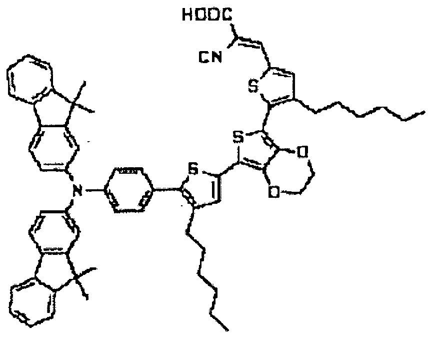

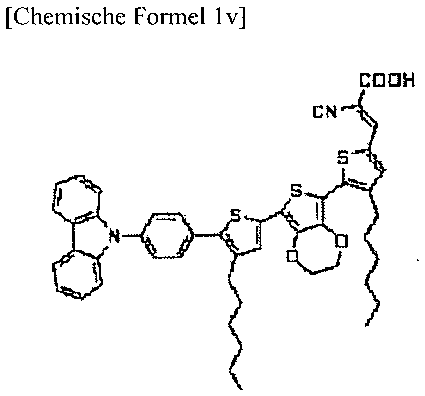

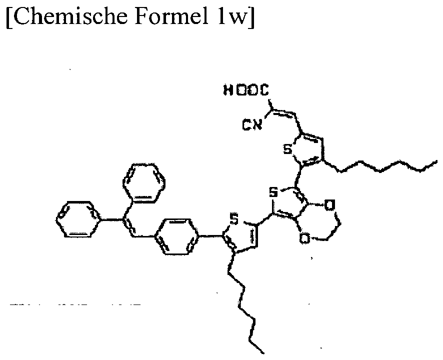

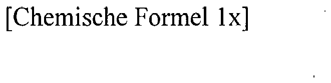

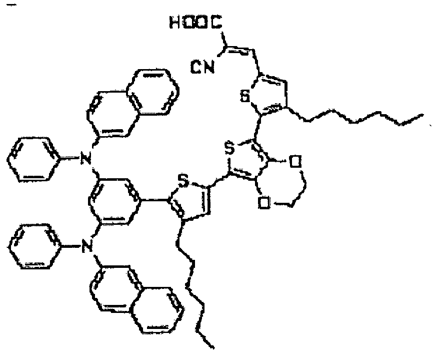

3. Verfahren zur Herstellung eines organischen Farbstoffs der folgenden chemischen Formel 1-1, aufweisend:
(1) Herstellen einer Verbindung der folgenden chemischen Formel 4 durch Suzuki-Kupplungsreaktion einer Verbindung der folgenden chemischen Formel 2 mit einer Verbindung der folgenden chemischen Formel 3,
(2) Herstellen einer Verbindung der folgenden chemischen Formel 5 durch Reagieren lassen der Verbindung der chemischen Formel 4 mit POCl₃ in einem organischen Lösungsmittel,
(3) Reagieren lassen der Verbindung der chemischen Formel 5 mit Cyanoessigsäure oder einer Verbindung der folgenden chemischen Formel 6 in CH₃CN in der Gegenwart von Piperidin: 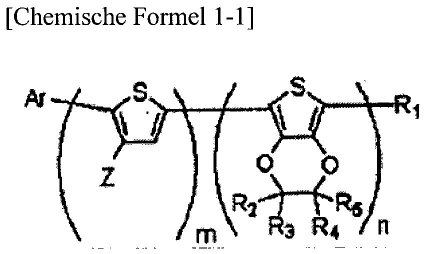 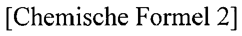 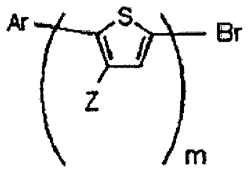 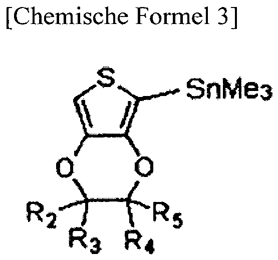 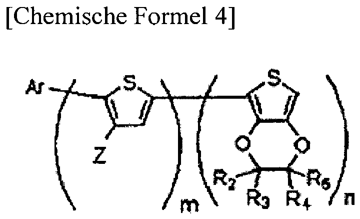 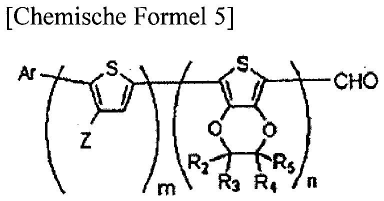 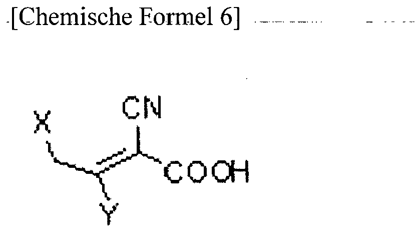 (wobei X, Y, R1 bis R5, Ar, Z, m und n wie in Anspruch 1 definiert sind).

4. Verfahren zur Herstellung eines organischen Farbstoffs der folgenden chemischen Formel 1-2, aufweisend:
(i) Herstellen einer Verbindung der folgenden chemischen Formel 4 durch Suzuki-Kupplungsreaktion einer Verbindung der folgenden chemischen Formel 2 mit einer Verbindung der folgenden chemischen Formel 3,
(ii) Herstellen einer Verbindung der folgenden chemischen Formel 7 durch Reagieren lassen der Verbindung der chemischen Formel 4 mit N-Bromstyrol in einem organischen Lösungsmittel,
(iii) Herstellen einer Verbindung der folgenden chemischen Formel 9 durch Suzuki-Kupplungsreaktion der Verbindung der chemischen Formel 7 mit einer Verbindung der folgenden chemischen Formel 8,
(iv) Herstellen einer Verbindung der folgenden chemischen Formel 10 durch Reagieren lassen der Verbindung der chemischen Formel 9 mit POCl₃ in einem organischen Lösungsmittel, und
(v) Reagieren lassen der Verbindung der chemischen Formel 10 mit Cyanoessigsäure oder einer Verbindung der folgenden chemischen Formel 6 in CH₃CN in der Gegenwart von Piperidin: 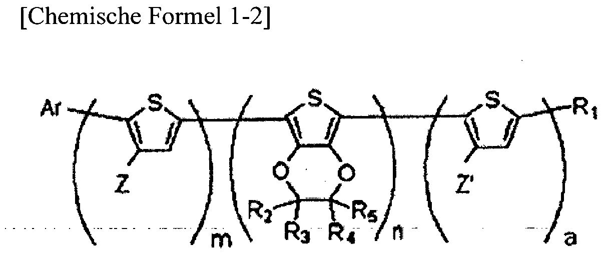 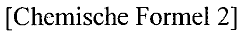 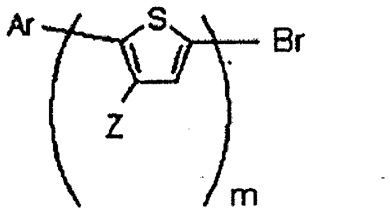 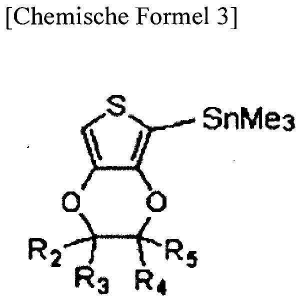 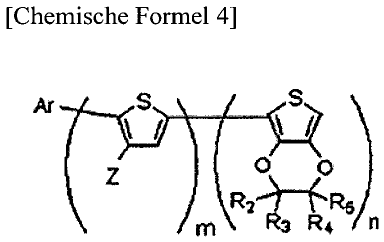 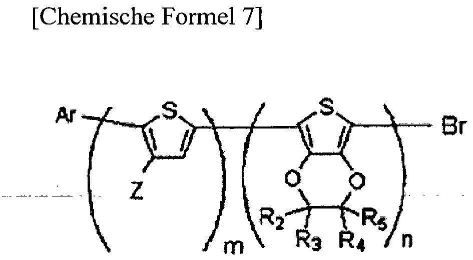 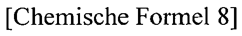 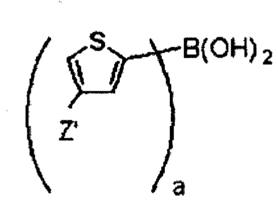 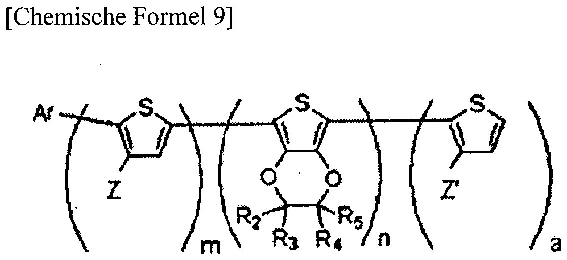 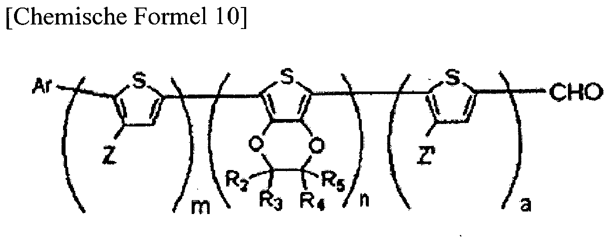 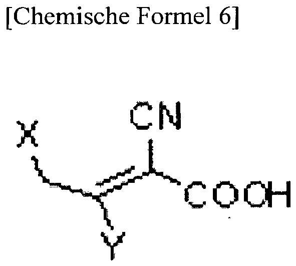 (wobei X, Y, R1 bis R5, Ar, Z, Z', m und n wie in Anspruch 1 definiert sind).

5. Farbstoffsensibilisiertes photoelektrisches Umwandlungselement, das Oxid-Halbleiter-Partikel aufweist, von denen der organische Farbstoff nach Anspruch 1 getragen ist.

6. Farbstoffsensibilisiertes photoelektrisches Umwandlungselement gemäß Anspruch 5, wobei der organische Farbstoff in den Oxid-Halbleiter-Partikeln in der Gegenwart einer Einschlussverbindung getragen ist.

7. Farbstoffsensibilisiertes photoelektrisches Umwandlungselement gemäß Anspruch 5, wobei die Oxid-Halbleiter-Partikel im Wesentlichen Titandioxid aufweisen.

8. Farbstoffsensibilisiertes photoelektrisches Umwandlungselement gemäß Anspruch 5, wobei das Oxid-Halbleiter-Partikel einen durchschnittlichen Partikeldurchmesser von 1-500nm aufweist.

9. Farbstoffsensibilisierte Solarzelle, die das farbstoffsensibilisierte photoelektrische Umwandlungselement gemäß Anspruch 5 als eine Elektrode aufweist.

10. Farbstoffsensibilisierte Solarzelle gemäß Anspruch 9, wobei die farbstoffsensibilisierte Solarzelle hergestellt ist durch Auftragen einer Titanoxid-Paste auf ein transparentes leitfähiges Substrat, Sintern des beschichteten Substrats zur Bildung einer Titanoxid-Dünnschicht, Tauchen des Substrats mit der darauf gebildeten Titanoxid-Dünnschicht in eine Mischlösung, in der der durch die chemische Formel 1 dargestellte Farbstoff gelöst ist, um eine farbstoffabsorbierte Titanoxid-Filmelektrode zu bilden; Bereitstellen eines zweiten Glassubstrats mit einer darauf gebildeten Gegenelektrode; Bilden eines Lochs, das das zweite Glassubstrat und die Gegenelektrode durchdringt; Platzieren eines thermoplastischen Polymerfilms zwischen der Gegenelektrode und der farbstoffabsorbierten Titanoxid-Filmelektrode und Wärmepressen von ihnen zum Verbinden der Gegenelektrode und der Titanoxid-Filmelektrode; Spritzen eines Elektrolyts in den thermoplastischen Polymerfilm, der zwischen der Gegenelektrode und Titanoxid-Filmelektrode liegt, durch das Loch; und Abdichten des thermoplastischen Polymers.

## Revendications

1. Teinture organique représentée par la formule chimique 1 suivante : 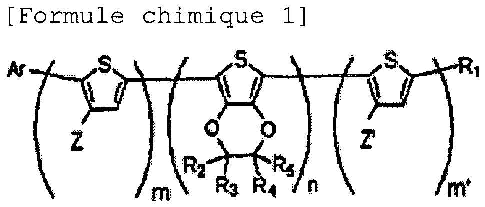 dans laquelle
R1 est 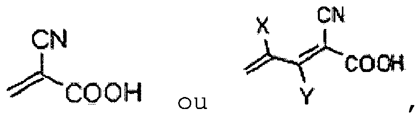 X et Y sont indépendamment hydrogène ou alkyle en Cl à 6 ;
R2 à R5 sont indépendamment hydrogène, alkyle en Cl à 30 substitué ou non substitué ou alcoxy en Cl à 30 ;
Ar est 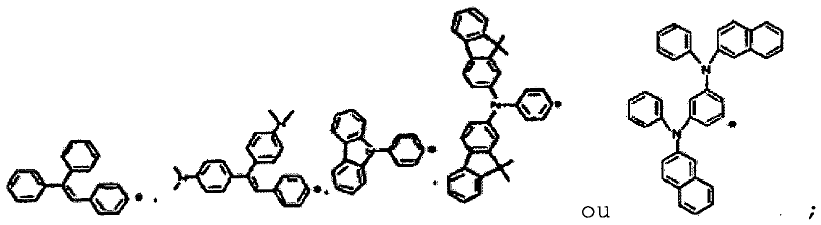
Z et Z' sont hexyle ;
n est un entier de 1 à 10 ;
m et m' sont indépendamment un entier de 0 à 5, à condition qu'à la fois m et m' ne soient pas simultanément O.

2. Teinture organique selon la revendication 1, dans laquelle la teinture est représentée par l'une des formules chimiques 1a à 1x suivantes :

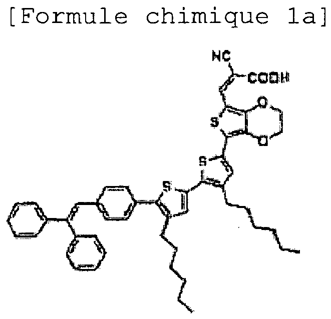

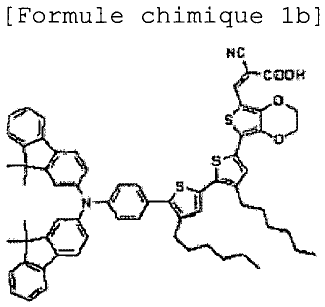

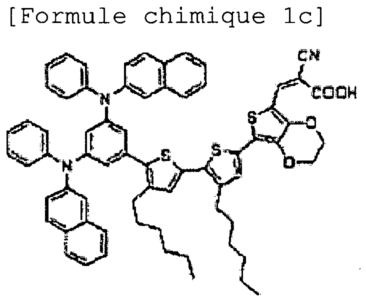

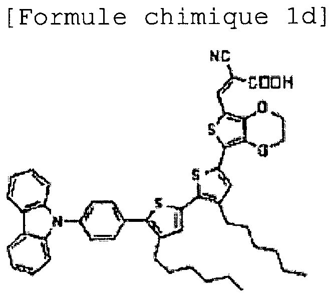

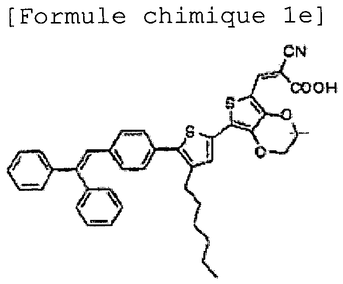

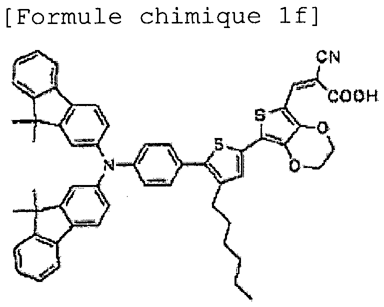

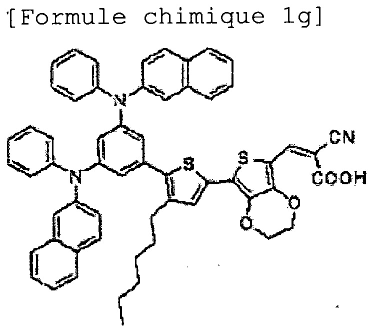

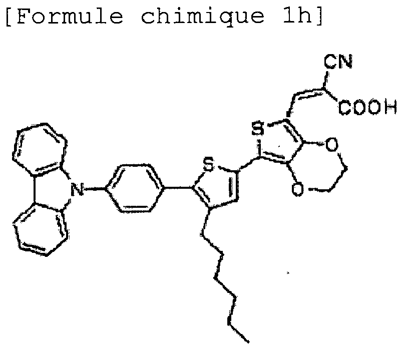

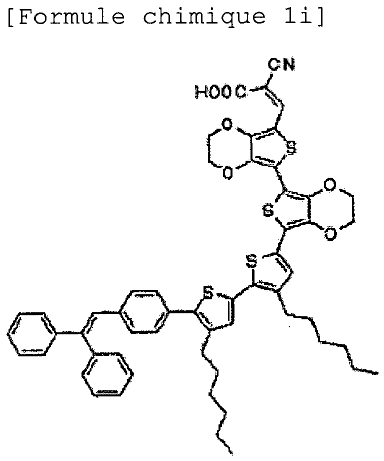

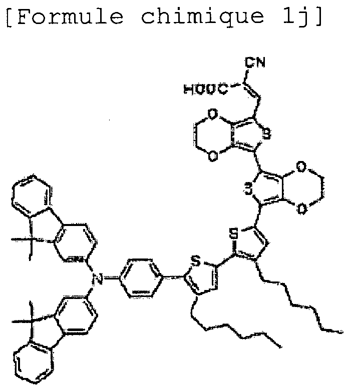

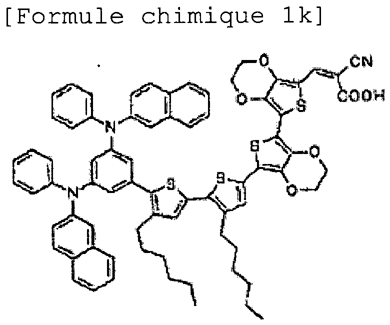

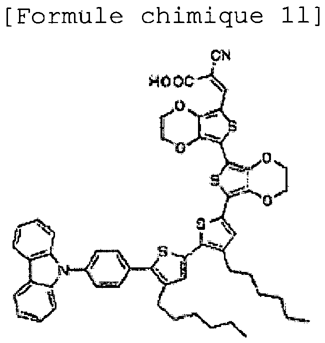

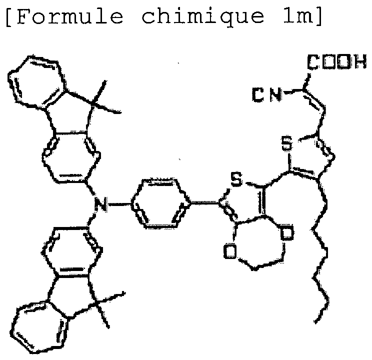

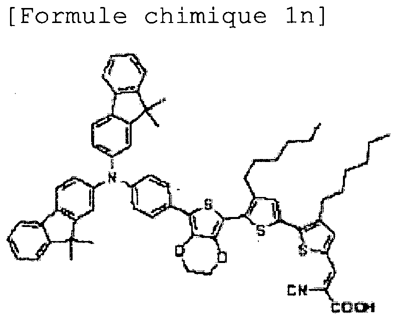

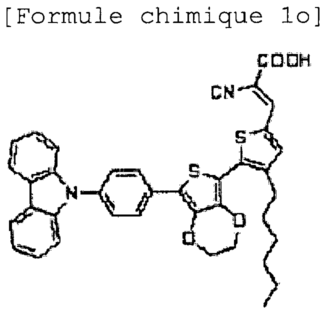

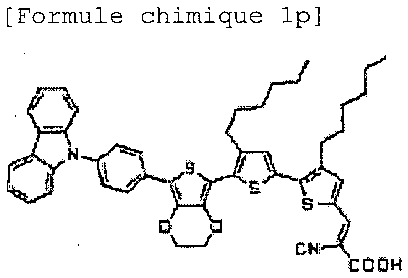

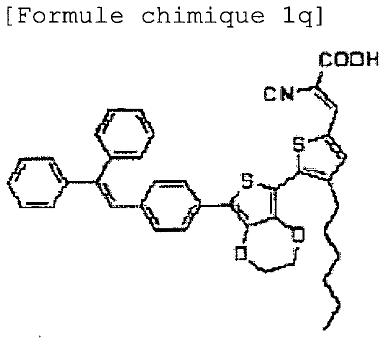

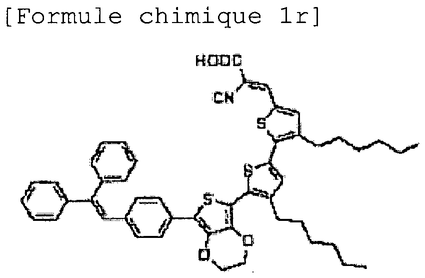

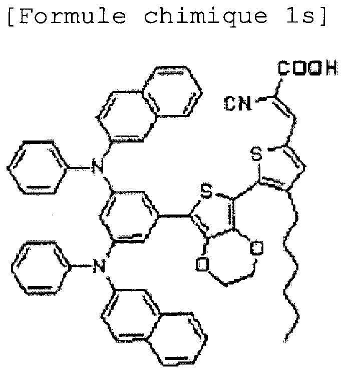

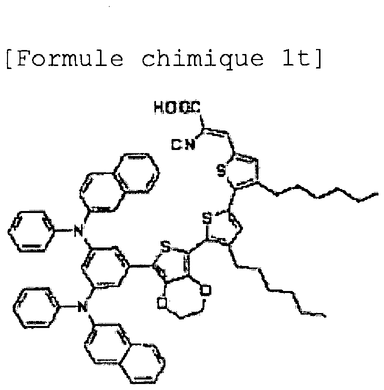

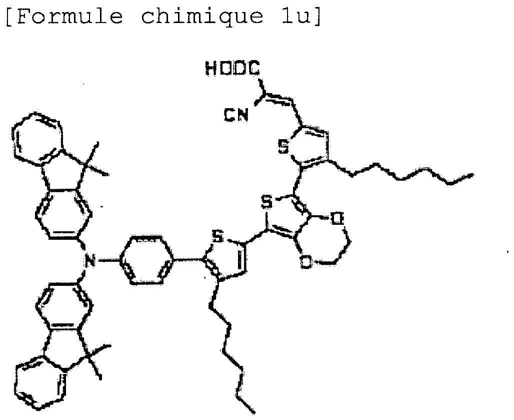

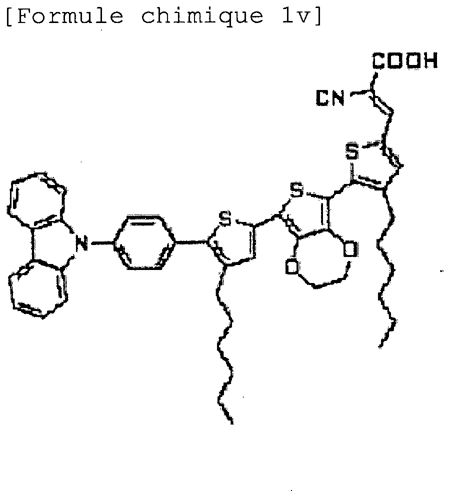

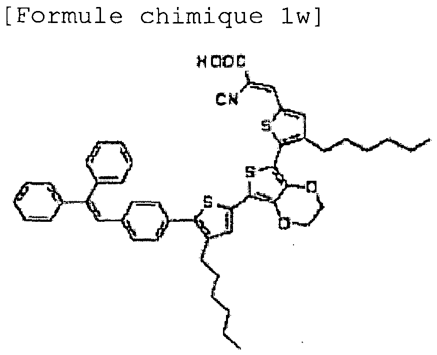

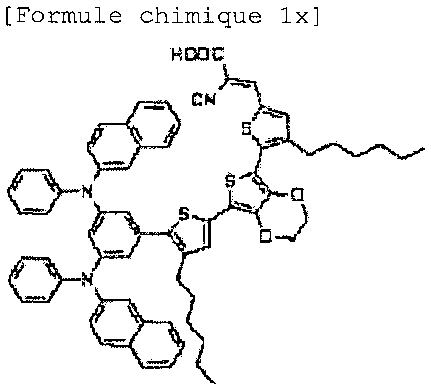

3. Procédé de préparation d'une teinture organique de formule chimique 1-1 suivante comprenant :
(1) la préparation d'un composé de formule chimique 4 suivante par réaction de couplage de Suzuki d'un composé de formule chimique 2 suivante avec un composé de formule chimique 3 suivante,
(2) la préparation d'un composé de formule chimique 5 suivante par réaction du composé de formule chimique 4 avec du POCl₃ dans un solvant organique,
(3) la réaction du composé de formule chimique 5 avec de l'acide cyanoacétique ou d'un composé de formule chimique 6 suivante dans du CH₃CN en présence de pipéridine : 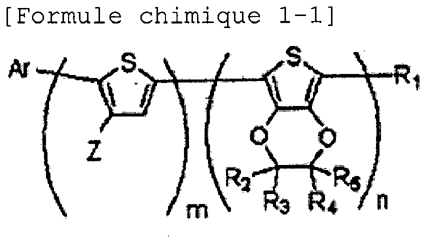 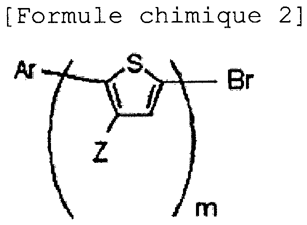 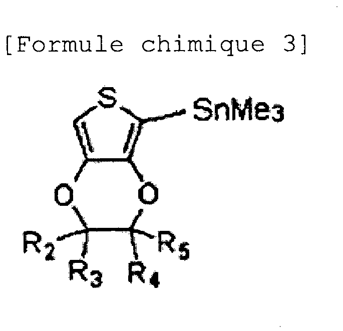 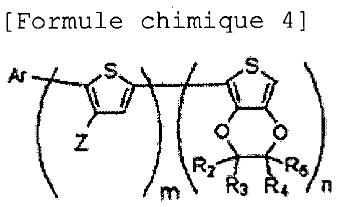 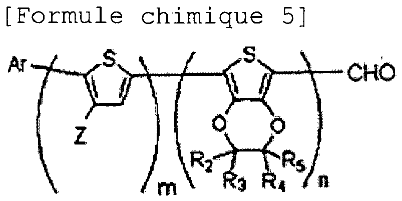 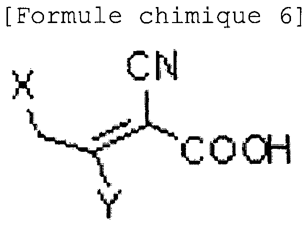 (où X, Y, R1 à R5, Ar, Z, m et n sont comme définis dans la revendication 1).

4. Procédé de préparation d'une teinture organique selon la formule chimique 1-2 suivante comprenant :
(i) la préparation d'un composé de formule chimique 4 suivante par réaction de couplage de Suzuki d'un composé de formule chimique 2 suivante avec un composé de formule chimique 3 suivante,
(ii) la préparation d'un composé de formule chimique 7 suivante par réaction du composé de formule chimique 4 avec du N-bromostyrène dans un solvant organique,
(iii) la préparation d'un composé de formule chimique 9 suivante par réaction de couplage de Suzuki du composé de formule chimique 7 avec un composé de formule chimique 8 suivante,
(iv) la préparation d'un composé de formule chimique 10 suivante par réaction du composé de formule chimique 9 avec du POCl₃ dans un solvant organique, et
(v) la réaction du composé de formule chimique 10 avec de l'acide cyanoacétique ou d'un composé de formule chimique 6 suivante dans du CH₃CN en présence de pipéridine : 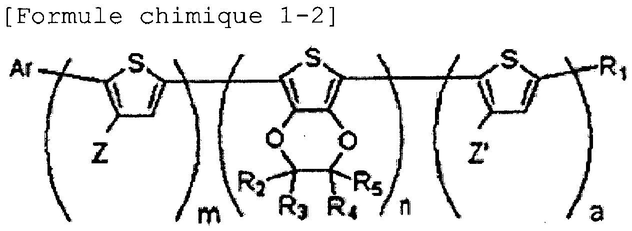 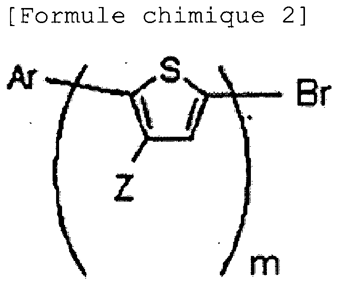 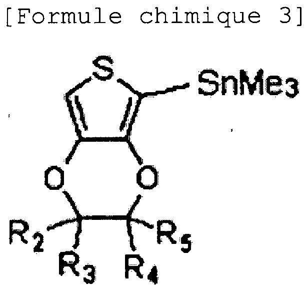 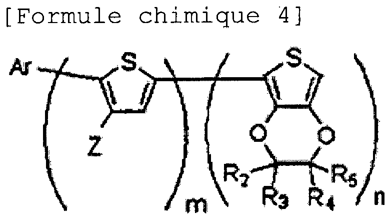 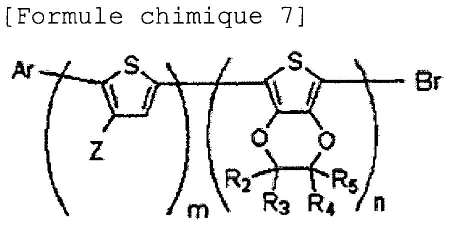 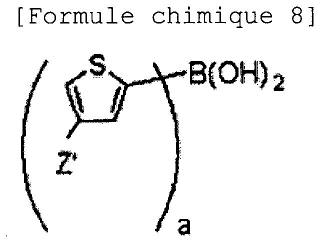 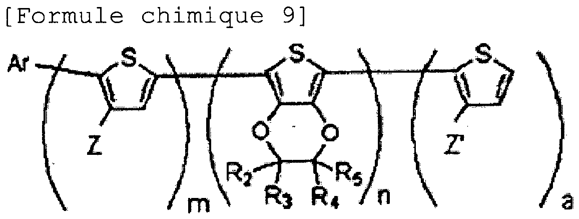 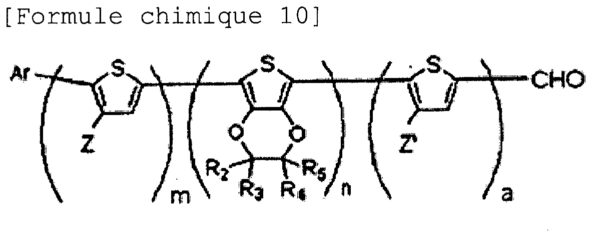 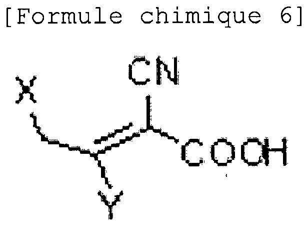 (où X, Y, R1 à R5, Ar, Z, Z', m et n sont comme définis dans la revendication 1).

5. Elément de transformation photoélectrique à teinture photosensible comprenant des particules de semi-conducteur à oxyde où la teinture organique de la revendication 1 est supportée.

6. Elément de transformation photoélectrique à teinture photosensible selon la revendication 5, dans lequel la teinture organique est supportée dans les particules de semi-conducteur à oxyde en présence d'un composé d'inclusion.

7. Elément de transformation photoélectrique à teinture photosensible selon la revendication 5, dans lequel les particules de semi-conducteur à oxyde comprennent essentiellement du dioxyde de titane.

8. Elément de transformation photoélectrique à teinture photosensible selon la revendication 5, dans lequel la particule de semi-conducteur à oxyde a un diamètre moyen de particule de 1 à 500 nm.

9. Cellule solaire à teinture photosensible comprenant l'élément de transformation photoélectrique à teinture photosensible de la revendication 5 comme électrode.

10. Cellule solaire à teinture photosensible selon la revendication 9, dans laquelle la cellule solaire à teinture photosensible est préparée par revêtement d'une pâte d'oxyde de titane sur un substrat conducteur transparent ; frittage du substrat revêtu pour former un film fin d'oxyde de titane ; immersion du substrat sur lequel est formé un film fin d'oxyde de titane dans une solution mixte dans laquelle la teinture représentée par la formule chimique 1 est dissoute, de façon à former une électrode à film d'oxyde de titane absorbée par teinture ; fourniture d'un second substrat de verre sur lequel est formée une contre-électrode ; formation d'un trou pénétrant le second substrat de verre et la contre-électrode ; placement d'un film polymère thermoplastique entre la contre-électrode et l'électrode à film d'oxyde de titane absorbé par teinture et leur pressage à la chaleur pour joindre la contre-électrode et l'électrode à film d'oxyde de titane ; injection d'électrolyte dans le film polymère thermoplastique placé entre la contre-électrode et l'électrode à film d'oxyde de titane à travers le trou ; et obturation du polymère thermoplastique.
